# EUROPEAN PATENT SPECIFICATION

(11) **EP 3 818 784 B1**
(45) Date of publication and mention of the grant of the patent: **29.11.2023**
(21) Application number: 19830706.8
(22) Date of filing: 02.07.2019
(51) Int. Cl.: G01N 21/66, G01B 11/00, G01N 9/24

(54) **OPEN-CIRCUIT ELECTROLUMINESCENCE**
ELEKTROLUMINESZENZ MIT OFFENEM STROMKREIS
ÉLECTROLUMINESCENCE EN CIRCUIT OUVERT

(30) Priority: 05.07.2018 US 201816027471; 05.04.2019 US 201916376643
(43) Date of publication of application: 12.05.2021
(73) Proprietor: Ahuratech LLC, Brighton, Michigan 48116 (US)
(72) Inventor: AKHAVAN-TAFTI, Hashem, Howell, Michigan 48843 (US); AKHAVAN-TAFTI, Mojtaba, Ann Arbor, Michigan 48105 (US); BOLANDI, Ali, Okemos, Michigan 48834 (US); HANDLEY, Richard, Canton, Michigan 48187 (US)
(74) Representative: Marks & Clerk LLP
(86) International application number: PCT/US2019/040256
(87) International publication number: WO 2020/010057

(56) References cited:
- WO-A1-01/24586
- KR-A- 20160 011 224
- KR-B1- 101 493 310
- US-A- 4 991 150
- US-A1- 2002 054 696
- US-A1- 2009 206 287
- US-A1- 2010 097 346
- US-A1- 2010 185 064
- US-A1- 2017 089 236
- US-A1- 2018 132 332
- US-A1- 2018 132 332

## Description

### FIELD

The present disclosure relates to methods and devices for generating light from electroluminescent devices under open-circuit conditions. The present disclosure further relates to uses of the present disclosure in the service of test methods and methods of detection.

### BACKGROUND AND SUMMARY

This section provides background information related to the present disclosure which is not necessarily prior art. This section provides a general summary of the disclosure, and is not a comprehensive disclosure of its full scope or all of its features.

Previous alternating-current electroluminescent devices require a first lead, wire or conductor to provide current through a first electrode to the device and a second lead, wire or conductor at a distinct location to transmit current across the electroluminescent material back to the source of electrical current. Examples of such devices can be found in US 2018/132332 A1, US 2002/054696 A1, KR 2016 0011224 A and US 4 991 150 A. Applicant has discovered that electrodes and leads that close a circuit from and back to a power supply or source of electrical energy are not required. It is only necessary to supply a time-varying electrical signal with a single lead, wire or conductor at a predetermined level to the electroluminescent device to create an electric field at the electroluminescent device and to provide a means whereby the electric field is increased sufficiently across the electroluminescent device to excite the electroluminescent device. This can be achieved by providing in close proximity to the electroluminescent device an object or substance that increases the electric field across the EL device. The invention is defined in the claims.

Further areas of applicability will become apparent from the description provided herein. The description and specific examples in this summary are intended for purposes of illustration only and are not intended to limit the scope of the present disclosure which is defined in the claims.

### DRAWINGS

The drawings described herein are for illustrative purposes only of selected embodiments and not all possible implementations, and are not intended to limit the scope of the present disclosure which is defined in the claims.
Figure 1 is a diagram depicting an example embodiment of a system using an LED lamp for producing electroluminescence in proportion to the amount of water in a container.
Figure 2 is a graph depicting the relationship between light intensity and water volume using an embodiment of the present disclosure.
Figure 3 is a diagram depicting an example embodiment of a system using a phosphor layer for producing electroluminescence in proportion to water quantity.
Figure 4 is a graph depicting the relationship between light intensity and water volume using an embodiment of the present disclosure.
Figure 5 is a diagram depicting an example embodiment of a system for producing electroluminescence in response to the amount of water in a container where electrical energy is interrupted by a dielectric layer.
Figure 6 is a graph depicting the relationship between light intensity and water volume using the experimental setup shown in Figure 5.
Figure 7 is a diagram depicting an example embodiment of a system for producing electroluminescence in proportion to the amount of water in a container where electrical energy is supplied to two LEDs in series.
Figure 8 is a diagram of an example embodiment of a system for producing electroluminescence in proportion to an analyte in a sample using transmission of electrical energy through the sample.
Figure 9 is a diagram of an example embodiment of a system for producing electroluminescence in proportion to an analyte in a sample.
Figure 10 is s a diagram of an example embodiment having a planar electroluminescent device for obtaining images of objects placed in contact.
Figure 11 is an image of a fingerprint obtained with the device of Figure 10.
Figure 12 is s a diagram of an example embodiment having a planar electroluminescent device with a dielectric layer for obtaining images of objects placed in contact.
Figure 13 is an image of a fingerprint obtained with the device of Figure 12.
Figure 14 is s a diagram of an example embodiment having a planar electroluminescent device with two dielectric layers for obtaining images of objects placed in contact.
Figure 15 is an image of a fingerprint obtained with the device of Figure 14.
Figure 16 is a graph showing the influence of various liquids on light emission.
Figure 17 is a diagram of a device for producing electroluminescence using a commercial LED immersed in a conductive medium.
Figure 18 is a diagram of a device for producing electroluminescence using a phosphor-coated electrode immersed in a conductive medium.
Figure 19 is a diagram of a device for producing electroluminescence using a phosphor-coated electrode with the power supply and/or electric field-increasing body also immersed in a conductive medium.
Figure 20 is a diagram of a portion of an EL device in accordance with the invention used to image an object and having a phosphor layer on a transparent electrode.
Figure 21 is a diagram of a portion of an EL device in accordance with the invention used to image an object and having a phosphor layer on a portion of a dielectric layer-coated transparent electrode.
Figure 22 is a diagram of a portion of an EL device in accordance with the invention used to image an object and having a phosphor layer sandwiched between dielectric layers on a transparent electrode.
Figure 23 is a diagram of a portion of an EL device in accordance with the invention used to image an object and having multiple phosphor layers sandwiched between dielectric layers on a transparent electrode.
Figure 24 is a diagram of a portion of an EL device in accordance with the invention used to image an object and having a metal nanoparticle layer and phosphor layer sandwiched between dielectric layers on a transparent electrode.
Figure 25 is a diagram of a portion of an EL device in accordance with the invention used to image objects and having a phosphor layer 4 in several segments sandwiched between dielectric layers on a transparent electrode.
Figure 26 is a diagram depicting an example embodiment of a system for producing electroluminescence in which a chosen object or body produces differing intensity light by varying the input electrical signal.
Figure 27 is a diagram depicting an example embodiment of a system for producing electroluminescence in which a water-filled hose is used to transmit time-varying electrical energy.
Figure 28 is a graph showing the variation of light intensity with water-filled hose length using the system of Figure 27.
Figure 29A is a diagram depicting an apparatus used in embodiments of the present disclosure.
Figure 29B is a graph showing the luminance response of an LED to time-varying input voltage according to an embodiment of the present disclosure.
Figure 29C is a graph showing change in light intensity (luminance) as a function of modulating DC input voltage into a power source producing an AC signal that is transmitted to an LED according to an embodiment of the present disclosure.
Figure 30A is a schematic diagram describing an example embodiment of a system for electroluminescence measurement of a contained fluid where an electrical terminal is in direct contact with the fluid.
Figure 30B is a schematic diagram describing an example embodiment of a system for electroluminescence measurement of a contained fluid where an electrical terminal remotely senses the fluid.
Figure 31A is a schematic diagram describing an example embodiment of a system for electroluminescence measurement of an object where a circuit component is in direct contact with the object.
Figure 31B is a schematic diagram describing an example embodiment of a system for electroluminescence measurement of an object where a circuit component remotely senses the object.
Figure 32 is a schematic diagram describing an example embodiment of a system for electroluminescence measurement of an object using a transformer.
Figure 33 is a diagram describing an example embodiment of a system for electroluminescence measurement of both the type and quantity of an unknown liquid. Corresponding reference numerals indicate corresponding parts throughout the several views of the drawings.

### DETAILED DESCRIPTION

Example embodiments will now be described more fully with reference to the accompanying drawings.

The present disclosure concerns methods, materials and devices for producing quantifiable electroluminescence. The present invention concerns methods as defined in the claims for producing electroluminescence at open circuit, termed open-circuit electroluminescence (OCEL). In particular, the present disclosure concerns methods of detecting and measuring a property of a material, object or substance based on the ability of the property to cause the generation of electroluminescence in such a method.

In the present disclosure, a physical property of an object is determined by a method involving measuring a change in electromagnetic radiation emitted by an electroluminescent device in proximity to the object. The terms change or alter, as used throughout the present disclosure, includes both increases and decreases in the intensity of electromagnetic radiation as well as changes in frequency or frequency range of the electromagnetic radiation emitted by the electroluminescent device.

In some embodiments, time-varying electrical signal from a power source is transmitted to one terminal of an electroluminescent device. An object is set in close proximity to a second terminal of the electroluminescent device, the object configured to cause a change in electromagnetic radiation of the electroluminescent device. The change in electromagnetic radiation of the electroluminescent device is measured by an electromagnetic radiation detector and related to a physical property of the object.

The present disclosure concerns methods, materials, and devices for producing electroluminescence at open circuit, termed open-circuit electroluminescence (OCEL). In particular, the present disclosure concerns methods of measuring a property of an object based on the ability of the property to interrupt the propagation of electrical signal in an open-circuit configuration and, therefore, cause a change in electromagnetic radiation of an electroluminescent device. In the present disclosure, open-circuit describes an electronic circuit where a time-varying electrical signal is transmitted from a power source to an electroluminescent device and other optional circuit components while the electronic circuit remains incomplete. Applicant has discovered that the use of the second additional electrodes and leads that close a circuit from a power source to the electroluminescent device and back to the power supply are not required. The electrical signal in an open-circuit configuration is particularly responsive to changes to physical properties of the media through which it propagates. The present methods take advantage of this responsiveness to the changes to physical properties of the media through which the electrical signal propagates. Here, the changes to electrical signal across an electroluminescent device are detected and related to changes to physical properties of the media through which the electrical signal propagates. In this application, the medium through which the electrical signal propagates is, as described herein generally referred to as an 'object' and can also include, but is not limited to, a material or a circuit component.

In one embodiment as defined in claim 1 there is provided a method for measuring a physical property of an object comprising:
a. transmitting a time-varying electrical signal from a power source to an electroluminescent device, wherein the electroluminescent device remains at open circuit;
b. positioning an object in close proximity to a terminal of the electroluminescent device while the time-varying electrical signal is transmitted to the electroluminescent device, such that a change in the physical property of the object alters the time-varying electrical signal across the electroluminescent device and thereby changes intensity of electromagnetic radiation from the electroluminescent device;
c. measuring the change in intensity of electromagnetic radiation emitted by the electroluminescent device; and
d. relating the measured change in intensity of electromagnetic radiation to a physical property of the object.

The positioning of the object in close proximity to the electroluminescent device while the time-varying electrical signal is transmitted to the electroluminescent device, may be such that the object increases the amplitude of the time-varying electrical signal across the electroluminescent device and thereby generates light from the electroluminescent device.

In another embodiment the method further comprises measuring the intensity of light and relating the light intensity to presence, position or quantity of the object or substance.

In another embodiment, said electroluminescent device comprises an electrode and a phosphor material layer deposited on a surface of the electrode, and the electroluminescent device remains at open circuit at all times; the step of positioning the object in close proximity to the electroluminescent device while the time-varying electrical signal is transmitted to the electroluminescent device, such that the object increases the amplitude of the time-varying electrical signal across the electroluminescent device and thereby generates light from the electroluminescent device.

In a further embodiment the method above further comprises measuring the intensity of light and relating the light intensity to presence, position or quantity of the object or substance.

In another embodiment, the method is directed to measure a property of a fluid comprising:
transmitting the time-varying electrical signal from the power source through the single electrical terminal to the electroluminescent device through the fluid,
wherein the electroluminescent device remains at *open-circuit* at all times; and
relating the measured light intensity to the property of the fluid.

### Definitions

Circuit Component: An electronic circuit is composed of individual circuit components, such as resistors, capacitors, inductors, solenoids, transformers, thermocouple, thermopile, electrochemical cells, power supplies, filters, diodes, and transistors. Circuit components are operably coupled to the electronic circuit. In some embodiments, conductive wires are used to operably couple a circuit component to an electronic circuit. Once operably coupled to an electronic circuit, a circuit component can impact an electrical signal transmitting through the electronic circuit.

Close Proximity: indicates any close spatial relationship effective for increasing the altering the electric field at the electroluminescent device and includes actual physical contact, or a zero separation distance. Distances greater than zero, i.e. non-contact, can also be used as long as the separation permits electric field alteration. Typical distances in practice will generally be on the order of 1 cm or less, and frequently 1 mm or less. A layer of dielectric material will provide a physical barrier between an electroluminescent device and the test object and thus determine a distance of physical separation. The dielectric so used can have a thickness in the range of 0.001 to 1 mm.

Capacitor Electrode: A capacitor electrode is defined as an electrode with differential electrical potential across its ends. Analogous to a capacitor whose 'plates' store charges of opposite polarity, i.e., positive and negative, a capacitor electrode holds unequal electrical potentials across its length resulting in a non-zero, residual electric field. The presence of this residual electric field will impact the electrical signal propagating along the capacitor electrode. A capacitor electrode can be one dimensional, e.g., wire, two-dimensional, such as a plate, or three-dimensional, i.e., hemispherical shell.

Contained Liquid: A contained liquid refers to a liquid whose physical properties including, but not limited to, volume, height, and dielectric constant are of interest. The liquid is stored in a container and its physical properties are measured. The liquid may be flammable, such as gasoline. The liquid may resist, block, or conduct the propagation of electrical signal.

Contained Solid: A contained solid refers to a solid whose physical properties including, but not limited to, volume, height, and dielectric constant are of interest. The solid is stored in a container and its physical properties are measured. The solid may be one piece or unit such as a slab or block, or it may be a collection of solid pieces, of similar or varying sizes, e.g. powders or granular materials. The solid may resist, block, or conduct the propagation of electrical signal. The present methods may also be used, for example, to assess moisture content, chemical composition, or electrical conductivity of metals.

Contained Gas: A contained gas is an object in gaseous phase whose physical properties including, but not limited to volume, pressure, temperature, dielectric constant, or moisture content are of interest. The object in a gaseous phase can also refer to a mixture of different gasses whose ratio(s) are to be determined. The gas can also include a vapor of a liquid.

It is to be understood that the term object as used throughout the application is considered to mean individual objects or things as well as quantities of a material or substance such as a liquid that may be contained in a container, or a length of wire or quantity of sheet, film or foil, etc. The term object may be used interchangeably with material, substance, or object.

The property of the object or substance can be any of a variety of physical or chemical properties. In various embodiments illustrated below, the property can be one of a group selected from volume, mass, area, length, distance, concentration in a solution, pH, ionic strength, ratio of two substances in admixture, polarity, conductivity, capacitance, and temperature. Various example formats and the means of using the present methods based thereon as a way of detecting, measuring or quantifying a property of the object or substance are described in more detail below in several non-limiting example embodiments.

Light-Emitting Diodes (LED): In some embodiments, of the present methods, the electroluminescent device is a light emitting diode or LED. Conventional LEDs feature a semiconductor chip surrounded by an epoxy shell with anode and cathode wires protruding. The semiconductor chip is doped to have p and n regions and create a p-n junction. A hallmark of LEDs is that current flow is unidirectional. In the present disclosure it has been found that the choice of which electrode is connected to the power supply is immaterial. Representative semiconductor materials found in LEDs useable in the present methods include GaAs, AlGaAs, GaAsP, AlGaInP, GaP, GaAsP, AlGaP, InGaN, GaN, and ZnSe. Such LEDs are commercially available and individual lights are available to produce any color in the visible spectrum. The methods of the present disclosure can involve the use of more than one LED bulb to produce electroluminescence. Arrays of a two- or three-dimensional shape are within the scope of the present methods as are assemblies of LEDs of different emission colors.

In another aspect of the present methods the electroluminescent device comprises an electrode and at least one phosphor material deposited as a layer on a surface of the electrode. In some embodiments, the phosphor material layer covers a discrete region of a surface of the electrode. In some embodiments, a phosphor material layer may cover a plurality of discrete regions of a surface of the electrode. The regions may be of any shape or dimensions and when a plurality of regions occur may be the same or different in size and shape. In certain embodiments wherein a plurality of different phosphor materials is used and wherein each region is covered with a single phosphor material, each of the different phosphor materials may be chosen to emit light of a different color. In this manner, various patterns may be produced, or different colors of light may result when the regions are small. A well-known example is the generation of white light by the mixing of red, green, and blue.

In another embodiment, the phosphor material layer comprises an admixture of different phosphor materials. This may be performed as another method of producing new or mixed colors as described above. In yet another embodiment a phosphor material may be combined into or embedded in a dielectric material.

Electrodes: The electrode used in the present methods may be of any practical or convenient shape or geometry as long as it is capable of bearing a layer of phosphor material on a surface. In some embodiments, the electrode may be planar. In some embodiments, the electrode may be curved. The electrode may advantageously be optically transparent such as glass coated with Indium-tin-oxide (ITO), fluorine-doped tin oxide (FTO), SnO2, Al-doped ZnO, Ga-doped ZnO, or other ternary or quaternary transition metal oxides as are known in the art. Glass coated with graphene, carbon nanotubes, and metal nanoparticles and/or nanowires are also considered within the scope of usable electrode materials.

It is anticipated that ancillary materials, such as conductors, metallic elements - clips, screws, nuts/bolts, pins etc. may be used in the construction and assembly of devices for performing the methods of the present disclosure. Selection of such materials is within the ability of the skilled person and does not depart from the inventive concept as defined in the claims.

Phosphors: Phosphor materials usable in the present disclosure can be any known substance or material known to generate electromagnetic radiation by application of an alternating or direct electrical signal . Exemplary materials can be selected from the group consisting of semiconductor particles, doped semiconductor particles, elemental Si particles, elemental Ge particles, quantum dots, fluorescent monomers, fluorescent oligomers, fluorescent polymers, phosphorescent monomers, phosphorescent oligomers, phosphorescent polymers and mixtures thereof. Phosphor materials may also have at least one of the properties of exhibiting fluorescence, delayed fluorescence or phosphorescence. In some embodiments, the phosphor is selected from a list of conductive wire and incandescent elements, such as tungsten wire and gold nanoparticles, wherein the phosphor emits electromagnetic radiation, such as infrared radiation, in response to application of an electrical signal.

Particulate Phosphor Materials: In some embodiments, phosphor materials are advantageously provided in the form of small particles, typically of a size less than about 0.1 mm (100 micrometers). In some embodiments, the particles will be less than about 1 micrometer. In other embodiments the particles will be nanoparticles in a size range of about 1-100 nm. In one embodiment nanoparticles are composed of a quantum dot semiconducting core material and a shell of a distinct semiconducting material. The core and the shell are typically composed of type II-VI, IV-VI, and III-V semiconductors, for example CdS/ZnS, CdSe/ZnS, CdSe/CdS, and InAs/CdSe. In some embodiments, the electroluminescent device comprises a quantity of nanoparticles of a material type known in the art to be capable of generating electroluminescence. Commonly these particles are made of inorganic semiconductor materials. One class of such electroluminescent materials comprises ZnS doped with a second metal. Incorporating small amounts of dopant elements in the nanocrystals enables adjusting of the color or wavelength of the electroluminescence emission from the nanoparticles. Included among these are ZnS doped with transition metals or rare earth metals. Representative examples include Mn (yellow-orange emission), Cu (green emission), Al, Sm, Tm, Er, Nd, or Eu. Other usable materials include semiconductors containing group III and group V elements, such as indium phosphide (InP), gallium arsenide (GaAs), and gallium nitride (GaN). Undoped and doped semiconductor particles may optionally be oxide-coated.

In another embodiment nanoparticles include a family of particles synthesized with the aid of a porous support material as disclosed in commonly owned co-pending US Patent Application Serial Nos. 15/240,271 and US 15/240,407. Such materials may be used with or without the support material being present.

Particles as used in the present application are not limited to any particular shape and may have different shapes, including spheres, cubes, rods, wires, or plates, or a mixture of shapes within any given sample portion.

In some embodiments, the phosphor material will comprise a continuous layer of an organic luminescent material. A plethora of such compounds are known in the literature and used at present, e.g. in producing thin film devices. Listings of such materials are found in many standard treatises on the subject. Commonly used OLED materials include polymeric materials such as polyphenylene (PPP), polyphenylene vinylene (PPV), polyfluorene, polyaniline, polythiophene (PT), and polyethylenedioxythiophene (PDOT), and small molecules, such as Alq3, metal phthalocyanines, and iridium or ruthenium organometallic complexes. The use of any such material is considered within the scope of the present methods. Devices containing two or more layers with different organic luminescent material in each layer are specifically considered to be usable in the methods of the present disclosure, particularly when more than one color of light is to be produced or when producing a composite color by combining different color emitters as is commonly done to produce white light by combination of red, green and blue light emission.

In some embodiments, the electroluminescent device further comprises the use of dielectric materials as layers or coatings. For example, a dielectric coating over a surface of the phosphor layer opposite the transparent electrode. In some embodiments, the electroluminescent device further comprises a dielectric coating between the transparent electrode and the phosphor layer. Dielectric coatings may, alternatively be used both over a surface of the phosphor layer opposite the transparent electrode and between the transparent electrode and the phosphor layer. Layers as used herein includes liquid materials applied and, if necessary, dried in place. Layers may be applied as a pre-manufactured thin film or as a tape. The thickness of the layer of dielectric material may be determined and adjusted as needed and by reference to the numerous examples reported in the patent and technical literature. Typical layers may range from 1 micron to 1 mm, for example and may optionally be of uniform thickness. The method of application of dielectric layer is not limited to any particular technique and may include dipping, applying a liquid layer and spreading, spin coating and other ways generally known in the art.

Dielectric Materials: Materials useful as dielectric materials in the present methods include, without limitation, BaTiO3, SrTiO3, barium strontium titanate, calcium copper titanate, nitrile rubber, vinyl glove material, paraffin, polymers including polyethylene, polyimide, poly(dimethylsiloxane), polystyrene, poly(methyl methacrylate), polypropylene, polyethylene terephthalate, polyurethanes, nylon polymers, acrylonitrile-butadiene rubber, vinyl rubber, glass, and graphene. Mixed dielectric materials are contemplated for use as well as using more than one discrete dielectric material in combination.

Object: as used in the present description refers to substances, materials and articles which may be conductive also are generally considered to be included. An exemplary listing includes, without limitation, metals, metal alloys, other solid substances of any shape or size, including granular or particulate materials and their mixtures, liquids chosen from among polar liquids, as well as mixtures of two or more liquids in any proportion, solutions containing dissolved solutes, other conductive materials such as solid or liquid conductive polymers are considered within the scope of the materials useful in the methods of the present disclosure. Living bodies, including plants and animals, parts of living bodies, a portion of a body tissue or a tissue section can all serve in this capacity in the present methods. As mentioned above, in some methods and applications an added circuit component can also serve as the object as described below. A more expansive description of exemplary materials is set forth in U.S. patent application Serial No. 16/027,421.

Where the object is a liquid or gaseous substance, it is to be understood that the liquid or gas may be enclosed within a vessel or container. Said vessel or container may contact the electroluminescent device. Common vessels and containers include, cups, test strips, test tubes, microwells, microwell strips or plates, and other conventional containers in common laboratory use. In such embodiments, the vessel or container comprises one or more walls having a thickness and the thickness establishes a separation distance between the electroluminescent device and the substance that alters the electric field when used in the present methods.

Physical property: includes any measurable property of an object or a substance including, without limitation, volume, mass, area, length, distance, position, orientation, speed, acceleration, displacement, density, concentration in a solution, pH, ionic strength, chemical composition, ratio of two substances in admixture, polarity, electrical potential, electrical charge content, conductivity, resistivity, capacitance, temperature, magnetic permeability, electric permittivity, refractive index, current density, vibration, oscillation, displacement, strain, stress, pressure, reflectivity, transparency, color, relative brightness, texture, rigidity, geometry, moisture content, absorptivity, energy, intensity, amplitude, frequency, mass-to-charge ratio, impurity, connectivity, mobility, viscosity, and pattern.

Power Source: The power source in some embodiments can be a cold cathode fluorescent lamp (CCFL) inverter. CCFL inverter operates at high voltage (few volts to tens of kilovolts) and high frequency (10-50kHz). CCFL are often used for backlighting liquid crystal display (LCD) panels. The CCFL models include for example: JKL components (BXA-24529, BXA-601), TDK (CXA-M10M-06Y15R, CXA-P1612-VJL, CXA-L0505-NJL), etc. CCFL circuits normally operate at an input voltage of 0-24 VDC. The voltage output of CCFL can be adjusted with modifying the inverter circuit elements and/or changing the input voltage. The latter was accomplished with the use of batteries, AC/DC transformer (adapters), and/or a lab-grade variable direct current (DC) power source. In particular, VOLTEQ HY3006D is a regulated linear DC power source and is continuously adjustable at 0-30 VDC and 0-6A. Plug & play systems are also within the scope of the present disclosure. In this case, the power supply is the typical North American/European power outlet with single-phase unit which has a 0-110/220VAC output voltage and frequency of 50/60 Hz. Other commercial wave generators can also be used. For instance, the SIGLENT SDG805 5MHz 125MSa/s Arbitrary Waveform Generator was used to generate time-varying electrical signal of various waveforms, including sine, square, ramp, pulse, and arbitrary/custom waveforms. The wave generator was further used to generate voltage and frequency sweeps ranging |Vpp| < 20 volts and f < 5 MHz, where Vpp and f represent the peak-to-peak voltage and wave frequency, respectively.

Time-varying electrical signal: as used in the present disclosure, includes modulating electrical signals such as an alternating current having a sinusoidal waveform of a wide range of frequencies. Frequencies useful in the practice of the present methods can range from 1 Hz to 200 kHz, or in some embodiments from 20 kHz to 50 kHz. Other forms of modulated amplitude signal that provide a change with respect to time are considered to be within the scope of the invention such as square waves, sawtooth waves and one or more pulsed electrical signals. The characteristics of an electrical signal include amplitude, frequency, waveform, phase angle, etc. Therefore, altering an electrical signal may refer to changing at least one of these characteristics. In some embodiments, the time-varying electrical signal switches between one or more states, such as a square wave, to improve system performance and/or to reduce power consumption.

Transmitting Media: The time-varying electrical energy is transmitted from the power source to the electroluminescent device by a transmitting conductor. Any material capable of transmitting an electrical signal, viewed as an oscillating electric field, can be used as a transmitting medium in the present methods. Conventional metal wires, leads, and connectors, including gold, silver, copper and aluminum may be used. Due to the lack of any required conductive path back to the power supply however, the choice of material for transmitting time-varying electrical power to the electroluminescent device is broader. In some embodiments, the transmitting conductor can be a fluid, more particularly, a liquid. Advantageously, the liquid may be an electrically conductive liquid. Water and aqueous solutions containing salts, for example can be used in this capacity. In embodiments of the present disclosure wherein the time-varying electrical power is transmitted to the electroluminescent device by a fluid, it has been discovered that the light intensity generated by the electroluminescent device is proportional to the quantity of the fluid. Such methods performed in accordance with this embodiment can therefore serve as a way of determining the quantity of the fluid, e.g. its mass or volume. More particularly, the method can serve as a way to determine the length of a column of fluid contained in a tube that contains the fluid. In other embodiments, the light intensity generated by the electroluminescent device is proportional to another property of the fluid. These other properties include for example, conductivity, dielectric constant, polarity, volume, concentration of a solute, or pH. Yet other embodiments can use a combination of two or more different materials, e.g. a conductive wire and a liquid-filled tube. In embodiments where the transmitting conductor or medium comprises a fluid, the material or object in close proximity to the electroluminescent device may be a simple metallic wire, such as one terminal of a commercially available LED lamp.

In some embodiments, the transmitting medium will be positioned between the electroluminescent device and the power source. In still other embodiments, the transmitting medium may fully or partially surround the electroluminescent device, in two dimensions or even completely envelop in three dimensions. In such formats, the electroluminescent device may be partially or fully covered with a dielectric material, but the methods of the present disclosure are not limited to these cases and no dielectric layer or barrier is required.

Conventional devices and apparatuses for producing electroluminescence feature a source of electric current transmitted through a wire to a lead or electrode coupled or connected to an electroluminescent device and further having a second lead or electrode that conducts current through a wire back to the source of electric current to close the electrical circuit, a so-called "closed-circuit" configuration. Applicant has discovered that the use of the second additional electrodes and leads that close a circuit from a power supply or source of electrical energy to the electroluminescent device and back to the power supply are not required. In other words, the electroluminescent device is at "open circuit" and yet produces light. It is only necessary to supply a time-varying electrical signal to the electroluminescent device and provide a means whereby the electric field is increased sufficiently in the region of space around the electroluminescent device. This can be achieved by providing in close proximity to the electroluminescent device an object or substance that increases the electric field across the EL device. Without wishing to be bound by any particular theory of operation, substances, materials and objects which can serve this purpose in the methods of the present disclosure include those which can store electric charge, i.e. demonstrate capacitance.

Further, it has been found that the time-varying electrical energy can be transmitted to the electroluminescent device through other types of transmission media. Representative transmission media can include liquids such as water, gases such as air, and solids.

In operation, the methods of the present disclosure for producing open-circuit electroluminescence (OCEL) provide numerous advantages compared to the conventional closed-circuit systems. Prior art closed-circuit technology operates in a manner governed by the capacitive characteristics of the electrodes and dielectric and emissive layers. The present methods are sensitive to any environmental variations in the properties of the electrode(s), EL device(s), dielectric layer(s), transmission media, and the material or the substance that causes the enhancement of electric signal across the EL device. The responsiveness to environmental conditions brings about advantageous operational and design flexibility characteristics which (without limitation) include:
1. Several substances can be examined simultaneously. The present methods and systems can examine various materials and their capacitive and/or (electromagnetic) conductive properties without the need to change any of the required elements of the system, i.e., time-varying power source, the energized electrode, as well as the emissive EL device. Dielectric layers are optional and can be a combination of various material/substances. This feature is uniquely of interest for the following applications: sensors, detectors, analytical instruments, etc.
2. Pattern recognition. Using a combination of EL material and/or dielectric layers, the OCEL system can detect patterns. This feature is particular interest for pattern recognition technologies, such as fingerprint characterization, tissue structural examination, etc. The pattern recognition capability has a resolution of 2nm.
3. The emissive EL layer can be changed for optimal results. As suggested in the below experiments, various phosphors respond best within a certain range of frequencies and electric field strengths. The ability to change the EL layer within the same system broadens the experimental conditions under which OCEL can operate.
4. Operates wirelessly. In the presence of a strong electromagnetic field, an OCEL system can operate without the need for a physical contact between the time-varying power source and the electrodes.
5. Operates within various media. As demonstrated below, OCEL can operate while submerged in polar (conductive) media. In this case, a water bath can serve as either the hot electrode and/or the substance which enables strengthening of the electric field across the EL device.
6. Operates in conjunction with other optical and electrical devices. Luminometers, spectrometers, CCD cameras, fiber optics, passive and adaptive optics can be coupled with the OCEL device to transmit the light output into a communicable signal.
7. Requires small input power to operate. The OCEL operates at or below a few watts.
8. Efficient. OCEL converts the majority of the input power into emission. The capacitive characteristic of OCEL eliminates the power waste (heat, current leak, etc.) associated with competing technologies.
9. Safe. OCEL operates within the RMS electrical current range of 1-200 µA which is well below the Occupational Safety and Health Administration guidelines (< 3 mA).
10. Free form. The OCEL system is not limited to a specific geometry of the subcomponents. Existing EL devices are only offered in planar (sandwich) or co-planar formats. Various 1D, 2D,& 3D format OCEL devices have been successfully tested.
11. EL material can be cast into shapes and in some cases held in place with dielectric material and/or the electrode. Unlike LEDs, the emissive layer can be formed into the desired shape. The shape will emit light when energized. This characteristic is of particular interest for consumer goods, entertainment, and lighting applications.
12. Multiple devices can be coupled. More than one OCEL device can be operated from the same time-varying power source.
13. Tunable emission color. Multiple EL materials can be used for optimal frequency and/or electrical current range. In addition, this feature allows for the production of emissions with various colors.
14. Tunable resolution. Various EL materials can be used to modify the resolution of the EL device.
15. Tunable EL layer lifetime. Existing EL devices use electrodes with finite light absorption, such as the ITO glass. This means that higher voltages must be applied in order to operate the EL device at the desired light output. Higher voltages lower the lifetime of the EL material. OCEL works with substances that help enhance the local electric field (such as water) where no absorption is expected. The lower required voltage increases the lifetime of the EL device.
16. Emissive layer can be coated with insulating material for improving durability and enhancing device lifetime.
17. EL layer can be applied onto the hot electrode or on the surface of the material or substance that helps to enhance the electric field across the EL device or be an independent layer. This feature will allow for a variety of applications, in particular, wireless applications.
18. Works without the need for a support material. All existing EL technologies depend on electrodes, as the support member, for holding the EL device and dielectric layer in place. Free-form OCEL works also in environments where the EL material is floatin (unattached) in a container.
19. Works independent of the direction of the applied time-varying electric energy. Unlike other unidirectional, diode-like EL devices, OCEL works regardless of the direction (positive-to-negative or negative-to-positive) of input voltage. This means that the EL device can be energized in any orientation. The signal can be with a positive or negative offset. The time average of the signal can be below or above zero.
20. Improved contrast ratio: The use of a combination of EL material and/or different dielectric layers allows the production of a system whose light output for electrical energy E1 and E2=(E1)/2 are easily distinguishable. This feature makes OCEL uniquely sensitive to small variations of the electrical energy applied across the EL layer.
21. Tunable dielectric layer: the change in the thickness (distance between the EL device and the conductive body), or the surface area of the electrode and/or the conductive body can change the light emission intensity. In addition, the light intensity can change depending on the type of dielectric used (ex. solutions of different dielectric constant).

Substances and Materials that Increase the Electric Field - Substances, materials and objects which exhibit electrical conductivity also are generally thought to be included in this category. Metals and metal alloys are representative exemplary materials. Metals useful in the practice of the present disclosure include, without limitation, gold, silver, copper, zinc, nickel, aluminum, alloys including brass, bronze, steel, and stainless steel.

In some embodiments, the object that serves to increase the electric field may be a quantity of a liquid chosen from among polar liquids including water, alcohols such as methanol, ethanol, 1-propanol, 2-propanol, ethylene glycol, glycerol, and propylene glycol, polar aprotic solvents including dimethyl sulfoxide, dimethyl acetamide, dimethylformamide, acetonitrile, as well as mixtures of two or more liquids in any proportion. Other conductive materials such as solid or liquid conductive polymers are considered within the scope of the materials useful in the methods of the present disclosure.

Various substances, materials or objects are useful in the present methods for placing in close proximity to the electroluminescent device in order to increase the electric field and thereby cause light emission from the electroluminescent device when time-varying electrical current has been transmitted thereto. These substances, materials or objects are not specifically limited by their physical size or shape. In some embodiments, where the substances, materials or objects are solids they may be in an approximate one-dimensional shape such as a wire of any convenient length. In other embodiments they may be in an approximate two-dimensional shape such as a sheet, leaf, roll, or panel of material and is not limited to any particular geometric shape. In still other embodiments they may be three-dimensional and take any desired shape. In certain embodiments it may be desirable to restrict the physical area of the substance, material or object in proximity to the electroluminescent material in order to concentrate the field-increasing effect to a localized region or area.

In embodiments wherein a liquid substance in close proximity to the electroluminescent device acts to increase the electric field across the EL device, the liquid may be enclosed within a vessel or container. Said vessel or container may contact the electroluminescent device. Common vessels and containers include, cups, test strips, test tubes, microwells, microwell strips or plates, and other conventional containers in common laboratory use. In such embodiments the vessel or container comprises one or more walls having a thickness and the thickness establishes a separation distance between the electroluminescent device and the substance that increases the electric field across the EL device when used in the present methods.

The liquid substance that increases the electric field across the EL device can in some embodiments be a solution comprising a solvent and at least one solute. In some embodiments, the solution can be an aqueous solution. The one or more solute may advantageously be selected, without limitation, from the group consisting of acids, bases, inorganic salts, organic salts, water-soluble organic solvents, water-soluble polymers, amino acids, peptides, proteins, drugs, dyes, enzymes, enzyme substrates, nucleotides, nucleosides, and nucleic acids and mixtures thereof.

Living bodies, comprising a substantial quantity of water, and parts of living bodies function in the capacity of increasing the local electric field and can serve in the present methods of producing electroluminescence. Living bodies includes plants and animals including mammals, especially the human body. In one embodiment, the present methods may be employed in service of producing a signal for creating an image of a fingerprint for identification or security purposes. The present methods can be applied to imaging other areas of skin, regions of other animal bodies and even inanimate objects and for obtaining information about the properties, including the size or surface characteristics such as textures of objects in contact.

In another embodiment, a part of a human body comprises a portion of a body tissue or a tissue section. Such a portion of tissue or tissue section is conveniently applied or adhered to a conventional glass slide of the type used in microscopy techniques. Such sections may be of any convenient thickness and thus are not particularly limited in this regard. Use of semiconductor phosphor particles of sufficiently small size or diameter permits microscopic imaging to be performed.

The substance used to increase the electric field across the EL device can be disposed relative to the other elements of the system in any convenient order or relationship. Although the term substance is used herein to describe materials that serve to increase the electric field, more than one such substance, operating together, can be used. In one embodiment, a wire or copper tape or both together may directly contact the electroluminescent device and another end of the wire is placed in contact with a vessel of liquid or another solid substance. Many additional exemplary combinations of such substances are shown in the examples below. In some embodiments, for example where the electroluminescent device is a planar support having a phosphor layer applied onto one surface, the field-increasing object, material or substance may be positioned in a region located distally from the power supply with regard to the phosphor material. In embodiments where the electroluminescent device is an LED bulb, electrical current may be transmitted to one of the cathode or anode legs and the field-increasing object, material or substance placed in close proximity to the other of the legs. In other embodiments the field-increasing object, material or substance can be positioned between the electroluminescent device and the power supply. In still other embodiments the field-increasing object, material or substance may wholly or partially surround in two dimensions or even completely envelop in three dimensions the electroluminescent device. In such formats the electroluminescent device may be partially or fully covered with a dielectric material, but the methods of the present disclosure are not limited to these cases and no dielectric layer or barrier is required.

Light Emission and Detection - The electroluminescent devices of the present disclosure generate light at wavelengths, more accurately ranges of wavelengths, governed by the emissive properties of the phosphor materials used. In general light is produced in a region of the electromagnetic spectrum spanning the ultraviolet, visible and near infrared wavelengths. One or more colors of light can be generated in the methods of the present disclosure by deliberate choice of phosphors.

Electroluminescent light produced in the present methods may be detected by any suitable means and is not limited to any particular mode of detection or visualization. Light produced in the visible portion of the spectrum can be detected by eye, for example. Other means of detecting the emitted light include digital cameras, photographic film, CCD chips, and sensor arrays. Commercial or purpose-built luminometers also can be used to detect and measure the electroluminescence produced in the present methods. Luminometers having a measurement chamber designed to house a single sample tube such as a Turner Designs TD 20/20 or similar can be used. Alternatively, luminometers designed to receive a 96-well microplate and measure each of the wells can also be used. In some embodiments, it may be desirable to select a portion of the wavelengths of light emitted. In such cases the method may further comprise the use of monochromators (prism or grating), or optical filters including low-pass, high-pass and notch or band-pass filters. Optical systems including microscopes using a variety of lenses for optical magnification and selecting a plane of focus can be used in some embodiments.

Applications of the Methods of the Invention - The methods of the present disclosure find many areas of applicability by making use of the fact that light intensity generated by the electroluminescent device is proportional to a parameter related to the substance placed in proximity to the electroluminescent device. In some embodiments, the parameter will be based on the quantity of the substance, e.g. the surface area, mass, volume or length of a column of sample. In other embodiments the light intensity will be relatable to a parameter based on some intrinsic property of the substance. When the term proportional is used herein it is understood to comprehend not just a simple 1 to 1 relationship or a linear dependence but also other numerical forms of relationships such as quadratic, other polynomial orders, logarithmic, exponential and the like. The important feature is that a dependence of light signal intensity and the measured parameter or property be established through measurement of a set of samples covering a range of values. Calibration curves or proportionality constants can thereby be derived. By use of such methods using the techniques of the present disclosure, analytical test methods can be developed which can be quantitative, semi-quantitative, qualitative, yes/no, cut-off or threshold value type tests.

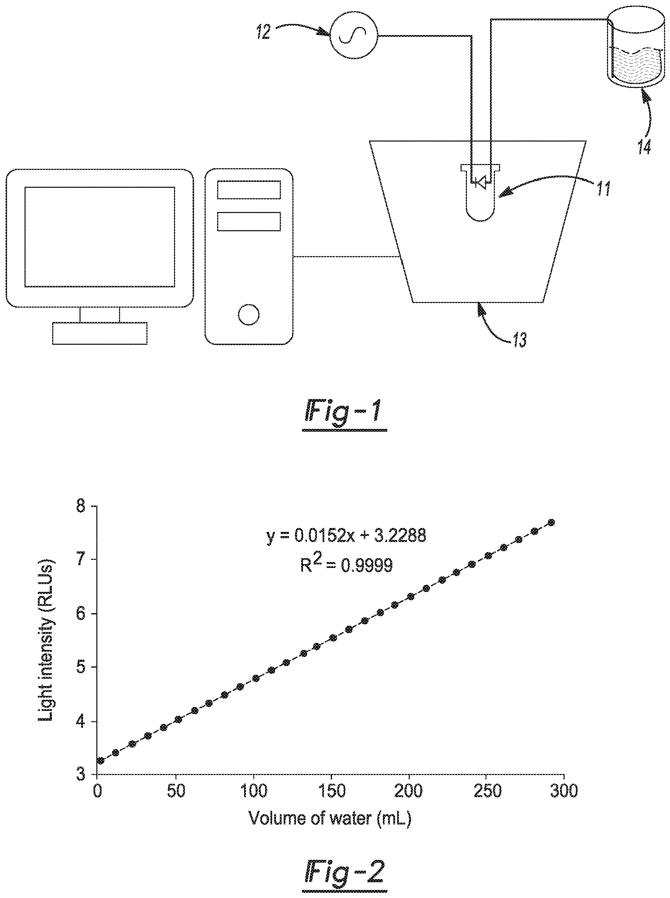

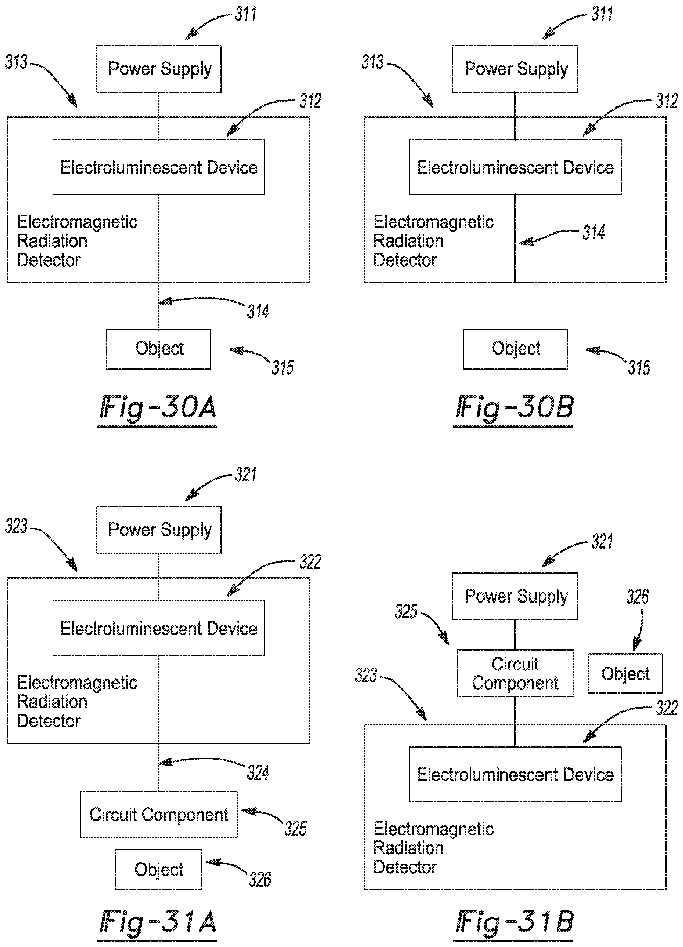

Fluid Level Sensing - Several different configurations of fluid level measurement systems can be devised, similar configuration as the US Patent *** (AliB's open circuit prior art app), and all are considered to fall within the scope of the present methods. Example systems of this configuration are provided in Figure 30A and Figure 30B. In each configuration, a time-varying electrical signal is transmitted from power source 311 to the electroluminescent device 312 contained within electromagnetic radiation detector 313. In Figure 30A, the capacitor electrode 314 is in direct contact with the object 315, in this case, gasoline. In Figure1 30B, the object 315 and the capacitor electrode 314 are separated, either by a layer of dielectric material or by a container wall. For example, suitable methods can include those in which:
1) a sensor is inside the fluid container, alongside the wall going to the bottom of the container,
2) a remote sensor is outside the container, alongside the wall of the container (a version of this configuration is a modified configuration 1 where the sensor is coated with a dielectric and is inside the container, but not in direct contact with the fluid because of the dielectric,
3) a remote sensor in which a large plate under the fluid container (a small plate will not give a linear correlation between the fluid level and the signal, rather it distinguishes between different types of fluids,
4) a container acts as electrode as when the container is a conductive material and is used to measure the level of the fluid inside it,
5) a container acts as electrode and the container either is insulated but has a conductive shell coating layer that plays the role of the sensor, or the container is conductive, but a layer of dielectric is separating the container from being in direct contact with the fluid.

Voltage sweeping - In an alternative method, instead of monitoring the change of signal for different levels of the fluids at a constant voltage, the input voltage of the power source is adjusted to affect the magnitude of the output time-varying electrical signal until the electroluminescent device emits at a preselected signal intensity. The Voltage value is then correlated to the level of the fluid inside the container. For example, the volume of the fluid samples can be derived from a calibration curve of voltage and fluid volume.

Test Methods - In some embodiments, the substance that alters the time-varying electric signal is an aqueous solution containing a solute and light intensity generated by the electroluminescent device is proportional to the amount or concentration of the solute in the aqueous solution. In some embodiments, the solute is the product of a chemical or biochemical reaction. In this way the method can be used for the purpose of monitoring the progress or extent of a reaction. An example reaction whose progress can be monitored would be a reaction that produces or consumes ionic species. When the solute that is produced or consumed is an acid or base then the method of the present disclosure can provide an indication of change of solution pH.

In some embodiments, the reaction solution comprises a solution containing an enzyme and an enzyme substrate and optionally a buffer and cofactors that promote enzyme activity and whereby the enzyme reacts with the substrate to produce the soluble reaction product and the amount of the reaction product is proportional to the light intensity produced.

In another embodiment the substance that alters the time-varying electric signal is a mixture of two liquids each of which is capable of increasing the electric field but to a different degree. In such embodiments the light produced will differ depending on the relative amounts or ratio of the two liquids. The ratio can be expressed in any suitable form, for example, as a weight percent, volume percent, or a molar ratio of each.

Additional uses enabled by the methods of the present disclosure include fingerprint detection, detection of liquids, for example as leaks in a liquid transport system, analyte detection, enzyme assays, depth sensors, distance sensors, and conductivity measurements. Other uses of the present methods not specifically listed here can be thought of by one of skill in the art by reference to the embodiments described and examples disclosed herein.

In some embodiments, the method can be used for measuring a single value of a physical property of an object. For example, an object is brought into proximity to the electroluminescent device as described above, the intensity of the electromagnetic radiation thereby emitted is measured and the intensity is compared to the intensity emitted in the absence of the object. Intensity so measured is related to the property of the object. The intensity can optionally be compared to the intensity emitted in the absence of the object.

In other embodiments, the method can be used for measuring a set or a series of values, i.e. a changing value, of a physical property of an object. In such a method, an object having a changing value of a property is brought into proximity to the electroluminescent device as described above. The intensity of the electromagnetic radiation thereby emitted is measured at fixed or irregular intervals over a period of time and the intensity determined at each time point. The intensities so measured are then related to a changing value of a property of an object. The information to relate the EL radiation to a physical property may be provided in a table or derived from a calibration curve particularly generated for the setup under study. The methods envision cases where the change in property is a continuing process and measurements are made continuously or at intervals as well as cases where the change in property is of a discrete nature, e.g. by measuring different regions of an object, different samples of an object, or different times.

In some embodiments, the time-varying electrical signal is transmitted wirelessly. In other embodiments, the time-varying electrical signal is transmitted from the power source to a terminal of the electroluminescent device by a wire or other electrically conductive media, including metals, other conductive solids, conductive liquids, and plasma.

Example embodiments are provided wherein the physical properties of a contained liquid are investigated. The physical properties are selected from a non-exhaustive list of quantity, height, level, volume, dielectric constant, polarity, and conductivity. A capacitor electrode is used to transmit an electrical signal from an electroluminescent device configured in an open-circuit configuration to the contained liquid. In other embodiments, physical properties of solid and gas materials are investigated.

The present methods can also be coupled to measure a plurality of physical properties of an object. To achieve this, one (or more) electrical signal of known characteristics is transmitted from at least one power supply to one (or more) electroluminescent device. More than one capacitor electrodes are then used to transmit the electrical signal(s) from the electroluminescent device(s) to the contained liquid which may or may not be in direct contact with one or more of the capacitor electrodes. It is required that at least one of the electroluminescent devices remains at open circuit.

In other embodiments of the present disclosure, a property of multiple different objects or multiple quantities of one type of object or substance can be measured. An example of the latter could be measuring each of the wells in a microwell plate. This method can be achieved by transmitting an electrical signal of known characteristics from a power supply to one (or more) electroluminescent device. A capacitor electrode for each well is then used to transmit the electrical signal from the electroluminescent device(s) to the contained liquid which may or may not be in direct contact with one or more of the capacitor electrodes. A separate electroluminescent device, such as an LED with a detector, can be used for each well. Alternately, one LED with one detector could be used for all of the wells and a system used which would only probe one well at a time. In another embodiment, multiple electroluminescent devices are used to generate electromagnetic radiation, wherein the electromagnetic radiation from each of the multiple electroluminescent devices are directed into one detector via electromagnetic wave guides such as fiber optics.

In another representative embodiment, two capacitor electrodes are used to measure two independent properties, e.g. the type and the quantity, of a liquid sample in a container. Below, an example embodiment is included wherein two capacitor electrodes are used to measure; a first to measure the ethanol content and a second to measure the quantity of gasoline. In one particular embodiment, two independent OCEL methods are positioned in close proximity of gasoline samples of variable quantity and ethanol content. The method is capable of performing two measurements which permit determination of sample volume and ethanol content in gasoline.

This embodiment is illustrative only and is not intended to present a comprehensive list of possible combinations of measuring a plurality of physical properties of an object. For instance, it is not required that the combination of methods used to work independent of one another. Also, it is not required to use more than one power supply, electroluminescent device, or electrode type, i.e., insulated capacitor electrode. Furthermore, the electrical signals generated by the one (or more) power supply may or may not be of identical characteristics, including, but not limited to, amplitude, frequency, waveform, and phase. Lastly, it is not required that all physical properties are measured with electroluminescent methods; this method can be coupled with conventional methods of determining physical properties of an object, e.g., spectroscopy, and can be coupled with "closed-circuit" methods.

Applicants have discovered that the range and scope of measurements using OCEL technology can be further expanded using an additional circuit component.

In one embodiment, the object can be a circuit component, wherein a physical property of the circuit component can be changed. Example systems of this configuration are shown in Figure 31A and 31B. In Figure 31A, the object 326 is positioned in close proximity to a circuit component 325 by a wire 324 that is connected to the electroluminescent device 322 contained within electromagnetic radiation detector 323 . In Figure 31B, the circuit component 325 is between the power source 321 and the electroluminescent device 322. The change in the physical property of the circuit component can alter the time-varying electrical signal across the electroluminescent device with which the circuit component is coupled causing the electromagnetic radiation emitted by the electroluminescent device to change. The change the electromagnetic radiation of the electroluminescent device is then measured and related to the physical property of the circuit component.

The circuit component is selected based on the types of physical properties to which the circuit component is receptive. For instance, an inductor may be used to measure magnetic properties of an object, i.e., to determine the extent to which magnetic properties of an object affects the characteristics of the electrical signal through the inductor. The order in which the electroluminescent device and the circuit component(s) are attached can vary. The electroluminescent device and the circuit component(s) can be coupled in series or parallel configurations.

Additional circuit components are selected, without limitation, from a list of inductors, solenoids, transformers, electromagnetic radiation sensors such as photodiodes and thermopiles, thermocouples, thermoelectric sensors, and piezoelectric sensors. These components are coupled with the present disclosure to broaden the types of measurable physical properties. In the following embodiments, an object is positioned in close proximity to a circuit component that is coupled to the OCEL methods discussed in the present disclosure. The changes to physical properties of the object will alter the characteristics of the electrical signal propagating through the circuit component and thus across the electroluminescent device.

Additional circuit components can be employed in a method for measuring one or more properties of an object. The component is configured to be electrically coupled to the electroluminescent device and to alter the electrical signal propagating through the electroluminescent device. Such components can be interposed between the power supply and the electroluminescent device or can be disposed so that the electroluminescent device is between the power supply the additional circuit component. In either arrangement the electroluminescent device remains at open-circuit.

Inductor: In some embodiments, an inductor is used to cause a change in electrical signal across an electroluminescent device. An inductor is defined as a coil, choke, or reactor. An inductor is a circuit component and is commonly a two-terminal electrical component that stores energy in a magnetic field when an electric current flows through it. An inductor typically comprises an insulated wire wound into a coil. In other embodiments, the term inductor is used to refer to a wire wound into a coil around a core. Properties/objects measurable by use of an inductor include displacement, distance, position, orientation, oscillation, vibrations, composition, volume, surface area, length, and conductivity.

In one experiment, an inductor comprising a wire wound into a coil around a core with two terminals was operably coupled to an electroluminescent device with a first terminal receiving time-varying electrical signal from a power supply and a second terminal. The two terminals of the inductor were directly connected to the second terminal of the EL device. The coupled inductor received a time-varying electrical signal. A metal piece was placed in known distance of 0.1 mm from the surface of the inductor which resulted in a change in EL device electromagnetic radiation (from 0 RLUs to 13,000 RLUs, RLU = relative light unit). Increasing the distance between the metal piece and the inductor resulted in incremental reductions in electromagnetic radiation (from 13,000 to 10,400 RLUs for distances 0.1 - 1.4 mm, respectively). A digital caliper with resolution 0.01 mm was used to measure distances. For 0.01 mm change in distance, there was 60 RLUs change in electromagnetic radiation intensity measured.

In another experiment, an inductor comprising a wire wound into a coil around a core with two terminals was operably coupled to an electroluminescent device with a first terminal receiving time-varying electrical signal from a power supply and a second terminal. The two terminals of the inductor were directly connected to the second terminal of the EL device. The coupled inductor received the time-varying electrical signal. An electromagnet was placed in close proximity (1 cm) to the inductor. A metal piece was placed on top of the inductor, between the inductor and the electromagnet, which resulted in a change in EL device electromagnetic radiation (from 1,850 RLUs to 2,000 RLUs). The electromagnet was connected to a power supply. Once energized, the electromagnet was capable of attracting the metal piece and separating it from the inductor surface. Increasing the distance between the metal piece and the inductor resulted in a reduction in electromagnetic radiation (from 2,000 to 1,850 RLUs). The power supply connected to the electromagnet was set to generate square waves of 200 and 500 mHz during which the electromagnet was periodically energized. The change in electromagnetic radiation was in phase with the change in the energization of the electromagnet and, therefore, the position of the metal piece. The resolution of the measurements is set by the resolution of the electromagnetic radiation detector.

In another experiment, an inductor comprising a wire wound into a coil around a core with two terminals was operably coupled to an electroluminescent device with a first terminal receiving time-varying electrical signal from a power supply and a second terminal. The two terminals of the inductor were directly connected to the second terminal of the EL device. The coupled inductor received the time-varying electrical signal. A wheel supporting four metal pieces organized in a predetermined manner. The wheel and the supported metal pieces were placed in a known distance from the surface of the inductor. Each metal piece caused a change in EL device electromagnetic radiation depending on the type and or its position on the wheel relative to the inductor. The electromagnetic radiation for each of the four metal pieces was determined (metal 1: 4170 RLUs, metal 2: 4110 RLUs, metal 3: 4100 RLUs, and metal 4: 4070 RLUs). Then the wheel is manually rotated around its axis. The period of the angular rotation was determined based on the change in electromagnetic radiation due to the four metal pieces. The resolution of measurement is a function of the number of unique combinations of metal pieces. Having knowledge of the radius of the wheel allowed the angular speed of the wheel to be indicated. In addition, the angle at which the wheel stopped was derived from the electromagnetic radiation data.

In some embodiments, the physical characteristics of a circuit component can be manipulated. For instance, physical characteristics of an inductor's core can be changed. In the following embodiment, the object whose properties change the electrical signal across the electroluminescent device is considered the core on the inductor. In this particular embodiment, the inductor is comprised of a coil wound around a container. Different quantities of a liquid are added to the container which causes a change in the electrical signal across an electroluminescent device. The change in the electromagnetic radiation is related to the quantity of the liquid.

In one experiment, an inductor comprising a wire wound into a coil around a core with two terminals was operably coupled to an electroluminescent device with a first terminal receiving time-varying electrical signal from a power supply and a second terminal. The two terminals of the inductor were directly connected to the second terminal of the EL device. The coupled inductor received the time-varying electrical signal. A dirt pile was placed in known distance of 0.1 mm from the surface of the inductor which resulted in a change in EL device electromagnetic radiation (from 6,220 RLUs to 6,620 RLUs). Increasing the moisture content of the dirt pile resulted in incremental enhancements in electromagnetic radiation. For instance, the electromagnetic radiation of the electroluminescent device increased from 6,220 RLUs to 6,820 RLUs for the addition of 1 mL of water to the dirt pile. The electromagnetic radiation was smaller for smaller additions of water (e.g., 20 RLUs increase in electromagnetic radiation for 100 uL of water). The applicant envisions a sensor to measure the moisture content of products such as grains and objects such as dirt for farming applications.

Spring Electrode: A spring electrode is similar to a solenoid and is a coil wound into a tightly packed helix. Compared to a solenoid, a spring electrode is flexible. The flexibility of a spring electrode is linked to its stiffness constant factor. The forces impacting an object attached to a spring electrode displace the spring electrode. Based on Hooke's Law, the spring electrode's displacement is a function of its stiffness constant factor and the forces. Properties measurable by use of a spring electrode include displacement, weight, and acceleration.

In one experiment, a spring electrode (a solenoid) comprising a wire wound into a coil with two terminals was operably coupled to an electroluminescent device with a first terminal receiving time-varying electrical signal from a power supply and a second terminal. One terminal of the spring electrode was directly connected to the second terminal of the EL device. The coupled spring electrode received the time-varying electrical signal. The second terminal of the spring electrode was connected to a stationary mass of 200 grams. At this point, the electromagnetic radiation of the electroluminescent device was measured at 7,700 RLUs. Once the mass was released the spring was stretched. The change in the length of the spring electrode resulted in a change in the electromagnetic radiation of the electroluminescent device. The oscillation and the time constant of damping of the oscillations were determined from the change in electromagnetic radiation. The electromagnetic radiation for when the spring electrode was at equilibrium and stationary, i.e., maximum stretching due to a mass of 200 grams, was measured at 8,400 RLUs. The experiment was done for various masses during which the change in electromagnetic radiation for individual test masses were recorded.

In another experiment, four spring electrodes were used with the objective to determine the location of a lever on a two-dimensional screen. To achieve this, four spring electrodes were connected to a lever on one end and to a conductive pin at each corner of a rectangular screen of dimensions 6" x 12". The lever was moved horizontally within the rectangular screen. The change in the location of the lever on the screen caused the four spring electrodes to displace, i.e., stretch, differently. The location of the lever was then determined by connecting the electroluminescent device to each of the conductive pins and measuring the extent to which each of the four spring electrodes was stretched. The applicant envisions a sensor, such as a gyroscope, to measure the location of a test mass attached to a plurality of spring electrodes organized in a predetermined format, in order to determine the orientation, oscillation, motion, etc. of the sensor.

In other embodiments, circuit components such as thermocouple electrodes, electromagnetic radiation detectors, and piezoelectric sensors can be used in a method to detect a property of an object wherein the property can be selected from a non-exhaustive list of environmental conditions such as temperature, pressure, electromagnetic radiation, and vibration.

Thermocouple: A thermocouple comprises a pair of non-identical conductive electrodes with different thermal conductivity properties. A residual electric potential difference forms between the two dissimilar electrodes due to the thermoelectric effect. This residual electric potential can impact the electrical signal propagating through a thermocouple. The magnitude of the residual potential difference is a function of temperature.

In one embodiment, a thermocouple is attached to a second terminal of an electroluminescent device of an OCEL system. The temperature of the environment surrounding the thermocouple is manipulated with the use of a heat gun. An electrical current is generated inside the thermocouple when the temperature changes. The generated electrical current of the order of microAmperes causes a change in electromagnetic radiation of the electroluminescent device. The change in electromagnetic radiation is then related to the amount of change in the temperature of thermocouple.

In one experiment, a thermocouple comprising a pair of metal wires of different physical properties was operably coupled to an electroluminescent device with a first terminal receiving time-varying electrical signal from a power supply and a second terminal. The pair of wires of the thermocouple were directly connected to the second terminal of the EL device. The coupled pair of wires of the thermocouple received the time-varying electrical signal. The pair of wires of the thermocouple was then placed in close proximity to a heat gun which resulted in rising temperature of the pair of wires of the thermocouple. The change in temperature and the resulting change in electromagnetic radiation were recorded. In one experiment, the electromagnetic radiation dropped from 8000 RLUs to 7300 RLUs as temperature of the pair of wires of the thermocouple changed from 45 to 70 degrees C, respectively.

Electromagnetic radiation sensor: in some embodiments, electromagnetic radiation sensors including but not limited to photosensors and thermopiles. The incoming electromagnetic radiation will cause a small current, of the order of microAmperes, to flow through the sensor that can be harvested and turned into measurable signal. This phenomenon is known as 'photoelectric effect.'

In one experiment, a thermopile comprising a plurality of terminals was operably coupled to an electroluminescent device with a first terminal receiving time-varying electrical signal from a power supply and a second terminal. Two terminals of the thermopile were directly connected to the second terminal of the EL device. The coupled thermopile received the time-varying electrical signal. The thermopile was then exposed to a source of thermal energy emitting infrared radiation. The background electromagnetic radiation was recorded at 7,800 RLUs. Once the infrared radiation source was turned on, the electromagnetic radiation of the electroluminescent device slowly increased to 9,200 RLUs within 25 seconds. Once the infrared radiation source was turned off, the electromagnetic radiation slowly returned to its original electromagnetic radiation values of 7,800 RLUs within 150 seconds.

In another experiment, a photodiode comprising a plurality of terminals was operably coupled to an electroluminescent device with a first terminal receiving time-varying electrical signal from a power supply and a second terminal. Two terminals of the photodiode were directly connected to the second terminal of the EL device. The coupled photodiode received the time-varying electrical signal. The thermopile was then exposed to a flash light. The background electromagnetic radiation was recorded at 8,000 RLUs. Once the flash light was turned on to 'dim', the electromagnetic radiation of the electroluminescent device immediately increased to 8,170 RLUs. The electromagnetic radiation of the electroluminescent device enhanced to 8,250 when the flash light became brighter. Moreover, when the flash light was set to generate blinking electromagnetic radiation, i.e., switching between on and off at a certain frequency, the electromagnetic radiation of the electroluminescent device modulated between 8,000 and 8,200 RLUs at 10 Hz, suggesting the frequency at which the flash light switched between 'off' and 'somewhat bright' statuses.

Piezoelectric Sensor: Piezoelectric sensor is hereby defined as a sensor that converts mechanical energy into electrical energy using the so called 'piezoelectric effect.' Mechanical energy can be in the form of acceleration, pressure, temperature, vibration, oscillation, strain, or force.

In one experiment, a piezoelectric sensor comprising a plurality of terminals was operably coupled to an electroluminescent device with a first terminal receiving time-varying electrical signal from a power supply and a second terminal. Two terminals of the piezoelectric sensor were directly connected to the second terminal of the EL device. The coupled piezoelectric sensor received the time-varying electrical signal. The piezoelectric sensor was then exposed to a source of mechanical energy. The mechanical energy was provided by a dielectric auxiliary rod. The background electromagnetic radiation was recorded at 12,760 RLUs. Due to impact from the auxiliary rod, the piezoelectric sensor is deflected resulting in the electromagnetic radiation of the electroluminescent device to decrease to 12,660 RLUs. More impactful events resulted in larger changes in electromagnetic radiation of the electroluminescent device. For instance, the electroluminescent radiation decreased to 12,525 RLUs when the impact caused the piezoelectric sensor to deflect up to nearly 90 degrees from it original position.

Transformer: In some embodiments, of the present disclosure, the electrical signal from the power supply can be transmitted to a primary coil of a transformer comprising two coils. The secondary coil of the transformer can then be used as a receiver. In the following embodiment, the electroluminescent device is attached to a coil which receives the electrical signal transmitted by a primary coil that is attached to a power supply.

In some embodiments, two insulated coils (the primary and the secondary coils) are coupled such that a time-varying electrical signal can be transferred between the two coils. The primary and the secondary coils are coupled such that the electrical signal from the power supply can be transferred between the coils wirelessly. In this case, the time-varying electrical signal in the primary coil will induce a time-varying electrical signal in the secondary coil.

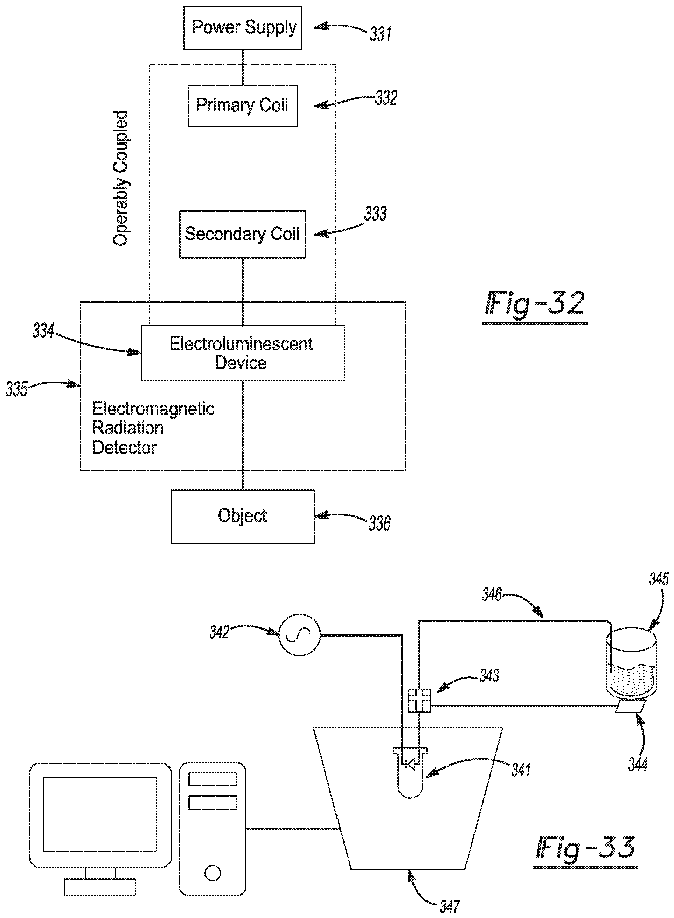

In one experiment, a transformer comprising a primary and a secondary coils were operably coupled to an electroluminescent device. An example teaching of this configuration is shown in Figure 32. The primary coil 332 of the transformer was connected to a power supply 31. The secondary coil 333 of the transformer was operably coupled with the first coil. A first terminal of an electroluminescent device 334 was connected to the secondary coil and thus received a time-varying electrical signal from the system of the power supply and the transmitting primary transformer coil. Electroluminescent device 334 is housed in a detection zone of 335 and placed in close proximity to object 336. In another experiment, the primary and the secondary transformer coils were placed around a microtiter well. The background electromagnetic radiation of the electroluminescent device was recorded at 9,750 RLUs. Adding droplets of water inside the microtiter well resulted in a change in the electromagnetic radiation of the electroluminescent device. Each additional water droplet caused an increase in the electromagnetic radiation of the electroluminescent device by 25 RLUs.

In some embodiments, the secondary coil is attached to a first terminal of an electroluminescent device. In other embodiments, a transformer comprises a core around which both the primary and secondary coils are wound. Changing the properties of the core can cause a change in the electrical signal, and therefore, a change in electromagnetic radiation of an electroluminescent device. In the following embodiment, the object whose properties change the electrical signal across the electroluminescent device is considered the core on the transformer. In this particular embodiment, the transformer is comprised of a primary coil and a secondary coil wherein at least one of the coils is wound around a container. Different quantities of a liquid are added to the container which causes a change in the electrical signal across an electroluminescent device. The change in the electromagnetic radiation is related to the quantity of the liquid.

The disclosed method further allows for measuring a physical property of an object using multiple techniques. The techniques will include at least one OCEL method. In one embodiment, the volume of a contained liquid inside a container of known dimensions is measured via:
a capacitive electrode, wherein the capacitive electrode is installed inside and extended along the body of the container,
an inductor, wherein the inductor is mounted below the container and electrically insulated from the liquid, and
an ultrasonic level indicator, the ultrasonic level controller installed over the container lid and is configured to actively transmit ultrasonic signal and to measure the reflected signal to determine the liquid height.

The three techniques report estimated volume of the contained liquid independently. The three independent measurements can then be cross-calibrated and compared for improved measurement accuracy. In some embodiments, the independent techniques can further identify the quality of the contained liquid. This information can then be used to derive the volume of the contained liquid. In some other embodiments, the shape, i.e., dimensions, of the container is predetermined.

Electrochemical cell: An electrochemical cell refers to a device for generating electricity via chemical reactions. A device that uses electricity to cause chemical reaction is also known as an electrochemical cell. One example of an electrochemical cell includes a battery comprising of a plurality of half cells. A battery is a device consisting of one or more electrochemical cells with external connections provided to power electrical devices. To power devices a redox reaction inside a connected battery converts high-energy reactants to lower-energy products. The free energy difference is provided to the device as an electrical current.

In one embodiment, the OCEL system is used to determine the rate at which electricity is generated by a chemical reaction. In the embodiment, an electrical current formed between two half cells of an electrochemical cell is measured by the amount of change the electrical current causes across an electroluminescent device connected to a source of time-varying electrical signal. In another embodiment, a capacitive electrode is used to measure the stored electrical charge inside an electrochemical cell, i.e., a battery.

In one embodiment, a capacitor of an unknown stored charge is brought in close proximity of an OCEL system. The change in electromagnetic radiation of the OCEL system's EL device is then related to the stored amount of charge inside the capacitor.

Example embodiments will now be described more fully with reference to the accompanying drawings.

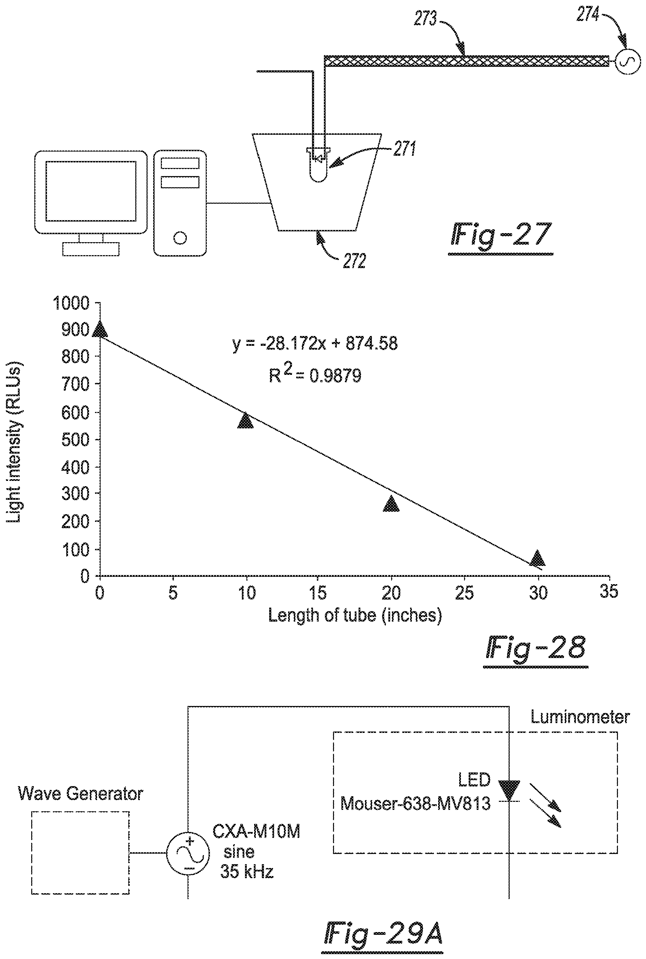

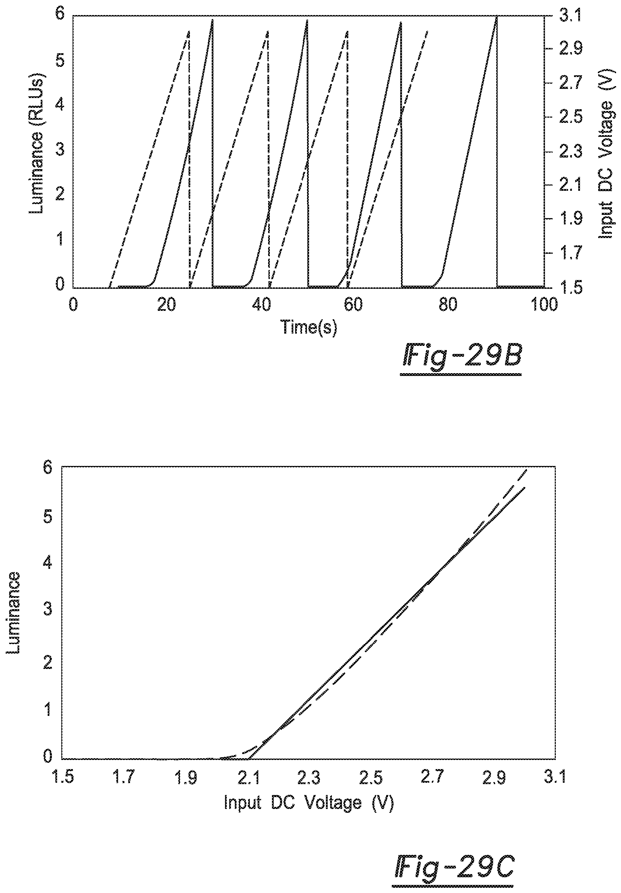

Description of a Representative Time-Varying Electrical Power Supply with Reference to Figure 29 - In one embodiment, a high-frequency (35kHz) CCFL circuit with adjustable input voltage was used to demonstrate the response-luminance profile of a red LED. CCFL circuit CXA-M10M-06Y15R was powered by a wave generator (BK Precision 4052). The system configuration of the CCFL circuit connected directly to an LED (Mouser P/N: 638-MV8113) in an open-circuit format and measured using a luminometer (TD-20/20, Turner Designs) are demonstrated in Figure 29A. In this example, the substance or material that alters electric field to enhance across the LED is a wire of unknown properties. A ramp waveform varying linearly between 1.5-3 VDC at 50 mHz was fed into the high frequency CCFL circuit. The luminance response of the LED to this input voltage is shown in Figure 29B. Similarly, Figure 29C shows how LED luminance changes as a function of modulating DC voltage. The polynomial fit suggests that the LED luminance can be defined as a second-order polynomial function of the input DC voltage. Modulating DC input voltage enables monitoring changes in the properties of the material or substance that alters the electric field across the EL device over time. The polynomial function may also give information regarding the physical properties of the substance or material of interest, including, but not limited to, the dielectric constant.

The change in luminance as a function of input voltage for any substance or materials of interest can thereby be examined and compared. Trial adjustment of input voltage in the system just described permitted it to be used to obtain the desired sensitivity and dynamic range of measurement for the several examples described below. Unless specified otherwise, the system described in this example was incorporated in the following worked examples.

Example 1 with Reference to Figures 1 and 2 - In a first example embodiment, an EL device was used in a method of the present disclosure to measure the effect different volume samples of water have on light intensity. A red LED 11 was used as the electroluminescent device. The LED 11 was placed inside a luminometer 13, with one terminal of the LED connected by a single wire to the time-varying power source described above 12. The other terminal of the LED was fixed at the bottom of a micro-container 14, so that the electroluminescent device was at open-circuit. The intensity of the light generated by the LED was measured by the luminometer and plotted over time. The light intensity of the open-circuit electroluminescent device with empty micro-container 14 was set as background. 2 µL of water was added to micro-container 14 and the change in the light intensity of the open-circuit electroluminescent device was recorded using the luminometer. Similarly, another 2 µL increment of water was added to the micro-container and the change in the signal was recorded. Extracted data show a linear relationship in Figure 2 between the intensity of the light from electroluminescent device and volume of the water added to the micro-container.

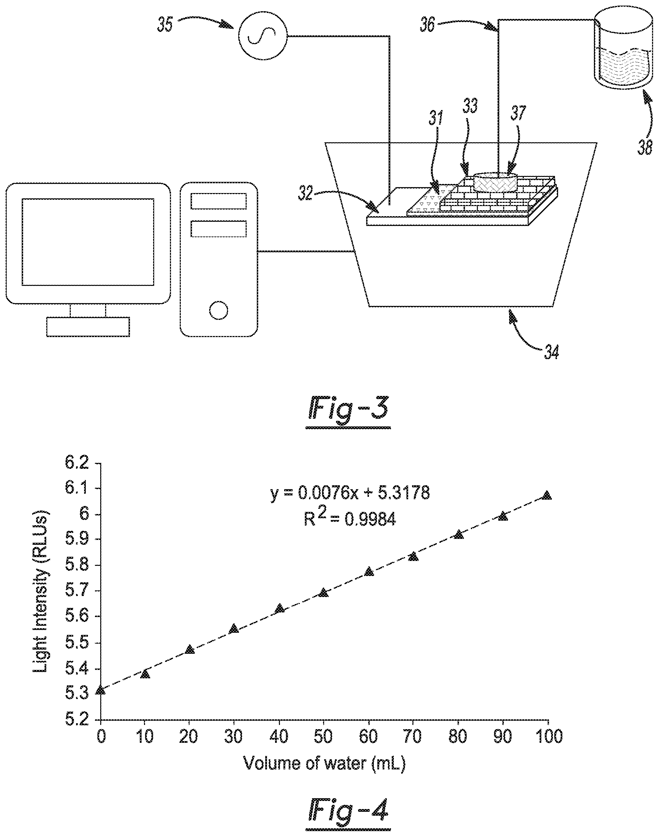

Example 2 with Reference to Figures 3 and 4 - In another example, water volume influence on light intensity was similarly measured, but using micron-size Cu-doped ZnS particles (phosphor particles) over the conductive side of an ITO glass as the electroluminescent device. To fabricate the electroluminescent device, a layer of phosphor particles 31 was deposited on the ITO glass 32 and the particles covered with a layer of dielectric tape 33. The electroluminescent device was placed inside a luminometer 34. The time-varying power source described above 35 was connected to the ITO glass by a single wire. A copper wire 36 was fixed over the dielectric layer using a round shape conductive copper tape 37 with the diameter of about 5 mm. The other end of the copper wire was fixed at the bottom of a micro-container 38, so that the electroluminescent device was at open-circuit. The intensity of the light generated by the electroluminescent device was measured by the luminometer and the results plotted over time. The light intensity of the open-circuit electroluminescent device with the empty micro-container was set as background. 2 µL of water was added to the micro-container and the change in the light intensity of the open-circuit electroluminescent device was recorded using the luminometer. Similarly, additional 2 µL increments of water were added to the micro-container and the change in the signal was recorded after each addition. Extracted data show a linear relationship in Figure 4 between the intensity of the light from electroluminescent device and volume of the water added to the micro-container.

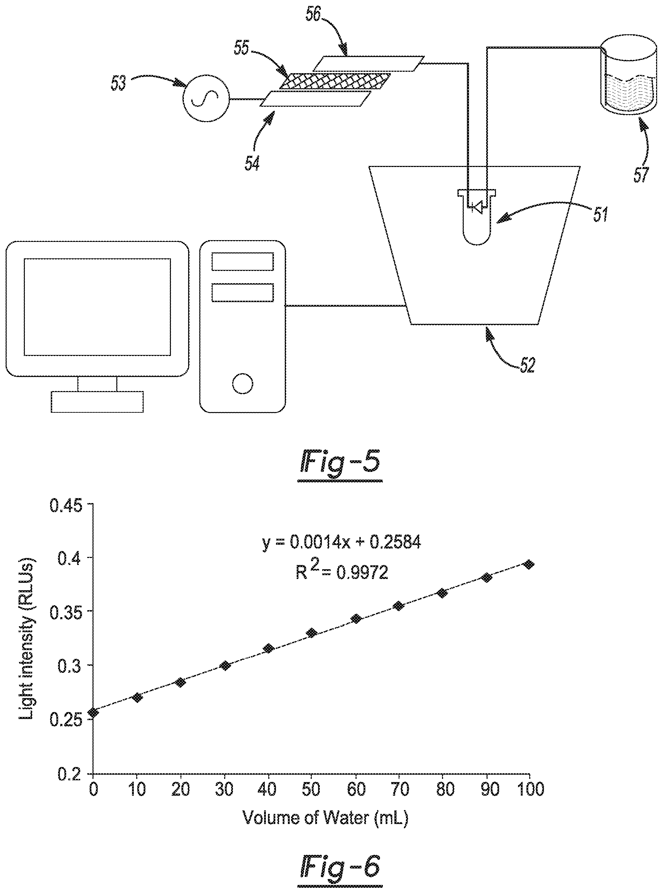

Example 3 with Reference to Figures 5 and 6 - In another embodiment, the effect of a water sample on light intensity was examined with a test system where the flow of electrical current from a source of time-varying electrical energy to an EL device is interrupted by a dielectric layer. To accomplish this, a red LED 51 used as the electroluminescent device was placed inside a luminometer 52. The time-varying power source described above 53 was connected by a single wire to a first metal strip 34. A layer of dielectric 55 was used to cover the first metal strip 54 and a second metal strip 56 was placed on top of dielectric layer 55. The second metal strip 56 was connected to one terminal of LED 51. The other terminal of LED 51 was fixed at the bottom of a micro-container 57, so that the electroluminescent device was at open-circuit. The intensity of the light generated by LED 51 was measured by luminometer 52 and plotted over time. The light intensity of the open-circuit electroluminescent device with the empty micro-container was set as background. 2 µL of water was added to micro-container 57 and the change in the light intensity of the open-circuit electroluminescent device was recorded using the luminometer. Extracted data show a linear relationship in Figure 6 between the intensity of the light from electroluminescent device and volume of the water added to the micro-container.

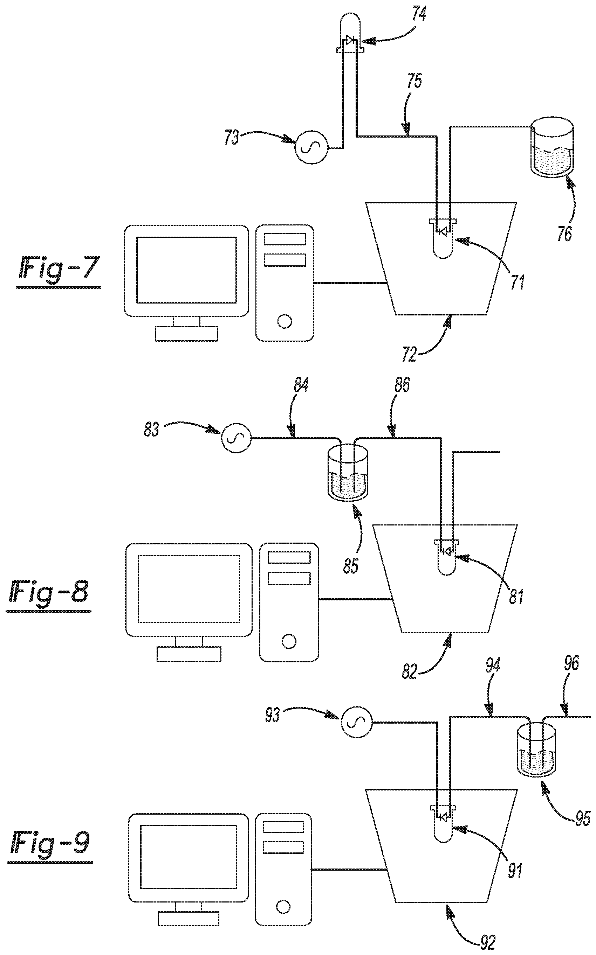

Example 4 with Reference to Figure 7 - In another embodiment, the effect of a water sample on light intensity was examined with a two LED system. A first red LED 71 was used as the electroluminescent device. The first LED was placed inside a luminometer 72. The time-varying power source described above 73 was connected to the first terminal of a second red LED 74. A metal wire 75 was used to connect the other terminal of second LED 74 to the first terminal of first LED 71. The other leg of the first LED was fixed at the bottom of a micro-container 76, so that the electroluminescent device was at open-circuit. The intensity of the light generated by the second LED was measured by the luminometer and plotted over time. The light intensity of the open-circuit electroluminescent device with empty micro-container 76 was set as background. 2 µL of water was added to micro-container 76 and the change in the light intensity of the open-circuit electroluminescent device was recorded using the luminometer. It should be noted that first LED 71 lights up as well.

Example 5 with Reference to Figure 8 - Measurement of Concentration of Ionic Solutions - In another embodiment, the method of the present disclosure was employed to perform measurements of the amount of a solute dissolved in a solution. A red LED 81 was used as the electroluminescent device. The LED was placed inside a luminometer 82. The time-varying power source 83 described above was connected to a single metal wire 84. The other end of metal wire 84 was fixed inside a container 85. One end of another metal wire 86 was also placed inside the container, so that the metal wire 84 and metal wire 86 are separated from each other and fixed at the same distance from the bottom of the container. The other end of metal wire 86 was connected to one terminal of the LED. The other terminal of the LED was not attached to anything so that the electroluminescent device was at open-circuit. A set of serial dilutions of aqueous solution of NaCl was prepared with the concentration of NaCl ranging from 1M to 10-6 M. 100 µL of the 10-6 M NaCl solution was added to the container so that ends of wire 84 and wire 86 were in contact with the solution. The resulting light intensity of the electroluminescent device was recorded using the luminometer. Similarly, the intensity of the light of the electroluminescent device was recorded for different concentrations of NaCl. Light intensity produced varied in proportion to the concentration of NaCl.

Example 6 with Reference to Figure 9 - Measurement of Enzyme Activity - In another embodiment, the method of the present disclosure was employed to perform an assay of the activity of an enzyme on a substrate. A red LED 91 was used as the electroluminescent device. The LED was placed inside a luminometer 92. The time-varying power source 93 described above was connected by a single wire to a first terminal of LED 91. The second terminal of LED 91 was connected to one end of a first metal wire 94. The other end of first metal wire 94 was fixed inside a container 95. One end of a second metal wire 96 was also placed inside container 95, so that the first metal wire 94 and the second metal wire 96 are separated from each other and fixed at the same distance from the bottom of container 95. The other end of second metal wire 96 was not attached to anything so that the electroluminescent device was at open-circuit.

A set of enzymatic reactions was prepared separately by mixing two solutions. Solution 1 is a working solution of known concentration of an enzyme substrate (ethyl acetate) in water. Solution 2 was one of a set of serial dilutions of aqueous solution of an enzyme (esterase), with an enzyme concentration ranging from 10 mg/mL to 1 µg/mL. Reaction of the enzyme with the substrate ethyl acetate converts it into ethanol and acetate. 100 µL of the set enzymatic reaction between the substrate and the 1 µg/mL enzyme was added to the container and the light intensity of the electroluminescent device was recorded using the luminometer. Similarly, reaction solutions were prepared using each enzyme dilution and the light intensity of the electroluminescent device was recorded for each enzymatic reaction. Light intensity produced varied in proportion to the concentration of enzyme.

Example 7 with Reference to Figure 8 - Alternative Measurement of Enzyme Activity - In another embodiment, the method of the present disclosure was employed to perform an assay of the activity of an enzyme on a substrate. In this variation, the assay sample was placed between the power supply and the EL device. A red LED 81 was used as the electroluminescent device. The LED was placed inside a luminometer 82. The time-varying power source 83 described above was connected to a first metal wire 84. The other end of first metal wire 84 was fixed inside a container 85. One end of a second metal wire 86 was also placed inside container 85, so that first metal wire 84 and second metal wire 86 are separated from each other and fixed at the same distance from the bottom of container 85. The other end of second metal wire 86 was connected to the first terminal of LED 81. The second terminal of LED 81 was not attached to anything so that the electroluminescent device was at open-circuit.. A set of enzymatic reactions were prepared separately by mixing solution 1 and solution 2, where solution 1 was a working solution of known concentration of an enzyme substrate (ethyl acetate) and solution 2 was a serial dilution of aqueous solution of an enzyme (esterase), with an enzyme concentration ranging from 10 mg/mL to 1 µg/mL. 100 µL of the set enzymatic reaction between the substrate and the 1 µg/mL enzyme was added to container 85 and the light intensity of the electroluminescent device was recorded using the luminometer. Similarly, the intensity of the light of the electroluminescent device was recorded for different set enzymatic reactions with different concentrations of the enzyme. Light intensity produced varied with the concentration of enzyme.

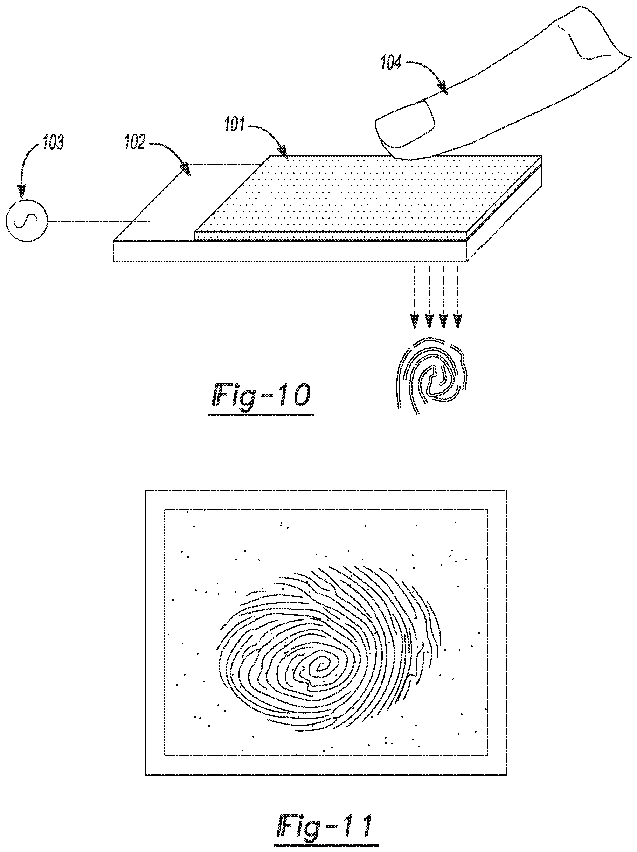

Example 8 with Reference to Figures 10 and 11 - In another embodiment, an imaging sensor having dielectric-embedded phosphor particles coated on ITO glass was used to obtain fingerprints. To prepare the device, micron-size Cu-doped ZnS particles (GG64) (Osram Sylvania Inc.) and Silicone elastomer curing agent were combined to form a "mixture" 101. The mixture 101 was dispersed on the conductive side of an ITO glass 102 and cured for 30 minutes at 70 °C to form a dielectric-embedded phosphor layer over the ITO glass. The time-varying power source 103 described above was connected by a single wire to ITO glass 102. A luminescent fingerprint shown in Figure 11 was observed on mixture 101 through ITO glass 102, upon placing a finger 104 on cured mixture 101. An image of the fingerprint was made with a CCD camera facing on the opposite side of the ITO glass.

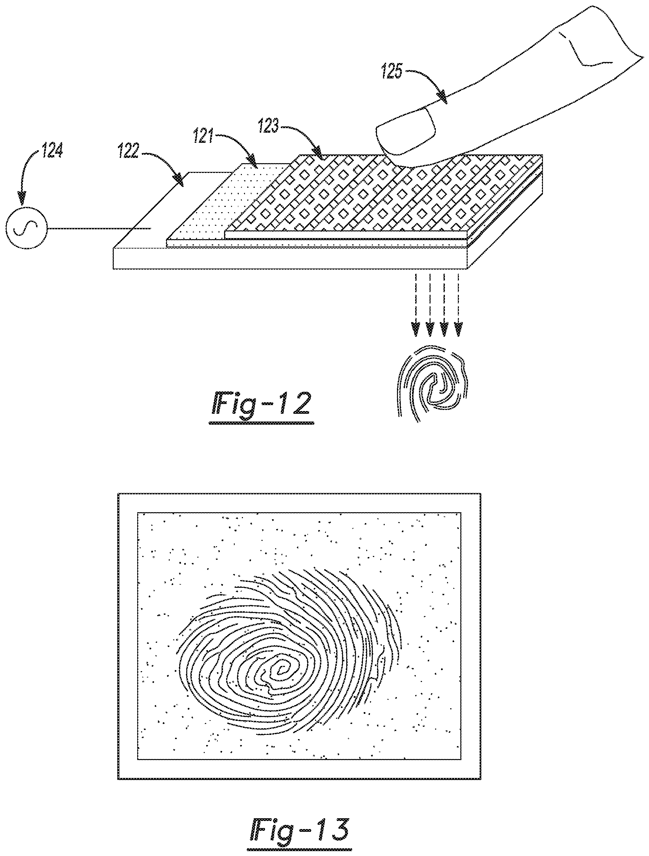

Example 9 with Reference to Figures 12 and 13 - In another embodiment, an imaging sensor having dielectric-embedded phosphor nanoparticles coated on ITO glass with a dielectric overlayer was used to obtain fingerprints. To prepare the device, a dispersion of 5 nm Mn-doped ZnS nanoparticles designated JS-43 prepared by the method disclosed in US 2018/0051209 was prepared in water. A layer of nanoparticles 121 was deposited on the conductive side of an ITO glass 122 by drying the suspension over the ITO glass. A layer of dielectric 123 such as a vinyl or nitrile rubber film, covered nanoparticle layer 121. The time-varying power source 124 described above was connected to ITO glass 122. A luminescent fingerprint shown in Figure 13 was observed on nanoparticles layer 121 through ITO glass 122, upon placing a finger 125 on dielectric layer 123. An image of the fingerprint was made with a CCD camera facing on the opposite side of the ITO glass.

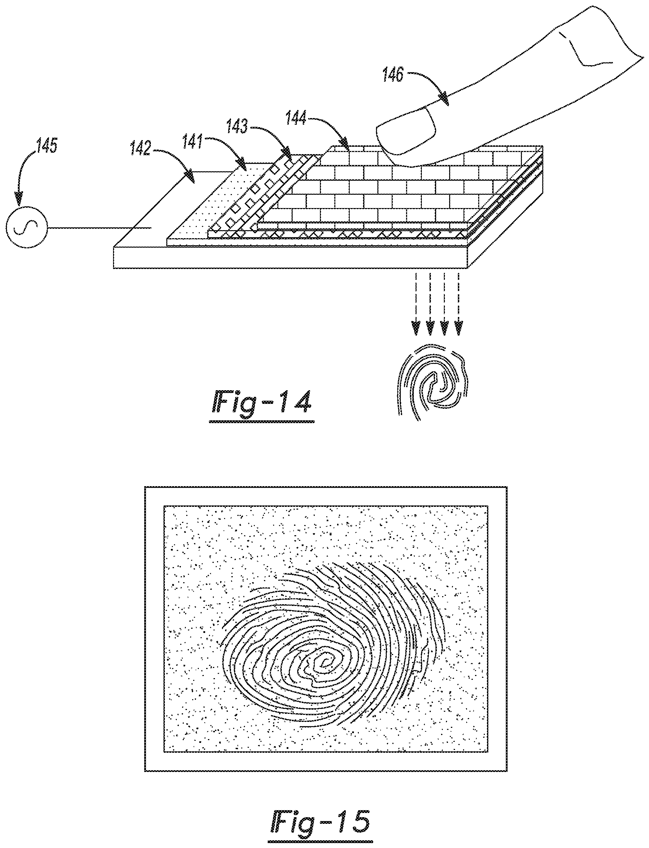

Example 10 with Reference to Figures 14 and 15 - In another embodiment, an imaging sensor having phosphor particles sandwiched between two dielectric layers coated on ITO glass was used to obtain fingerprints. To prepare the device, a first dielectric layer (barium titanate in commercial binder resin, or a thin polymer layer) 141 was coated on ITO glass 142. A layer of GG64 particles 143 was deposited on a first dielectric layer 141, followed by depositing a second dielectric layer 144 over phosphor material layer 143. The time-varying power source 145 described above was connected by a single wire to ITO glass 142. A luminescent fingerprint shown in Figure 15 was observed on phosphor material layer 143 through ITO glass 142, upon placing a finger 146 on dielectric layer 144.

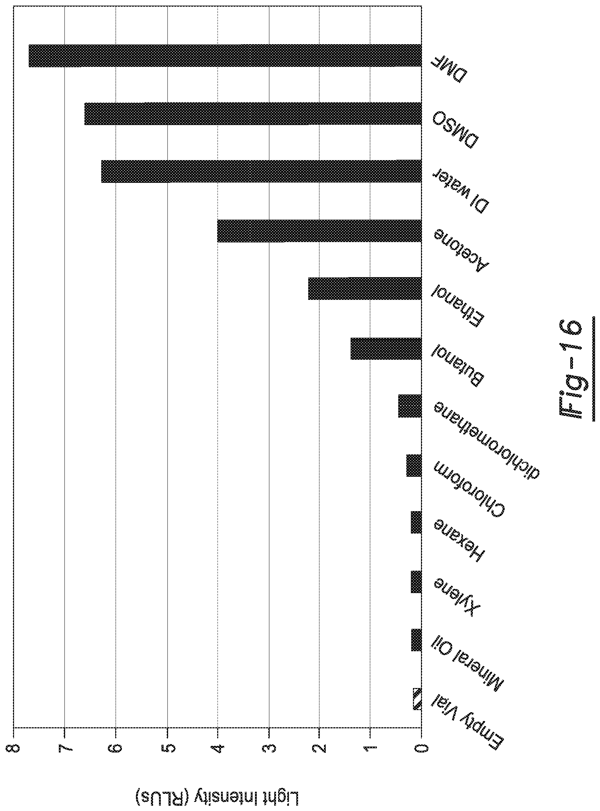

Example 11 with Reference to Figure 16 - In another embodiment, the effect of different substances on light emission was examined. A red LED 161 was used as the electroluminescent device. LED 161 was placed inside a luminometer 163, with one terminal of the LED connected by a single wire to time-varying power source 162 described above. The other terminal of the LED was fixed at the bottom of a micro-container 164, so that the electroluminescent device was at open-circuit. The intensity of the light generated by the LED was measured by the luminometer and plotted over time. The light intensity of the open-circuit electroluminescent device with empty micro-container 164 was set as background. A set of different solvents was used as the object or substance that increase the electric field. For each solvent from the set of different solvents, 5 mL of the solvent was added to container 164 and the light intensity of the open-circuit electroluminescent device was recorded using the luminometer. The results shown in Figure 16 and Table 1 show that light intensity increases with increasing polarity of the material.

**Table 1. Light Intensity Produced with Different Liquids**

| **Solvent** | **Luminometer reading (RLUs)** |
|---|---|
| Empty Vial (BG) | 0.1385 |
| Mineral Oil | 0.175 |
| Xylene | 0.178 |
| Hexane | 0.19 |
| Chloroform | 0.2741 |
| Dichlorometha ne | 0.429 |
| Butanol | 1.381 |
| Ethanol | 2.193 |
| Acetone | 4.021 |
| DI water | 6.25 |
| DMSO | 6.58 |
| DMF | 7.64 |

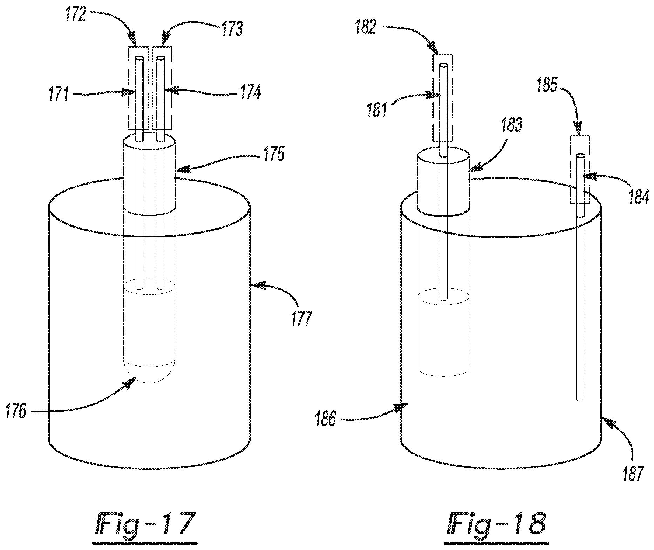

Example 12 with Reference to Figure 17 - In these embodiments, EL devices were excited in a conductive medium using a device depicted in Figure 17. In these embodiments, an insulated LED was submerged in water. The water may optionally contain minerals for enhanced conductivity. The LED leads were connected via insulated wires to a time-varying power source on one end and to a ground on the other. In each of the alternative embodiments in this example, the object that increases the electric field across the EL device is the water bath and an optional second object connected to the EL device directly. Light intensity produced is correlated to the presence and size of the field-increasing object(s). The following combinations were tested and produced electroluminescent light:

Both LED leads were connected directly to a time-varying power source and a material or substance that enhances electric field across the EL device. As shown in Figure 17, the LED terminals 171 and 174 are connected directly to a material or substance that enhances the electric field across the EL device and the time-varying power source described above, without a dielectric layer 172 and 173. A water-insulation layer 175 separates the LED 176 from the water bath 177.

B. Both LED leads were connected to a time-varying power source and a material or substance that enhances electric field across the EL device via dielectric layers. In this embodiment, the LED terminal 171 and 174 were connected to a material or substance that enhances electric field across the EL device and the time-varying power source described above, via a dielectric layer 172 and 173, respectively. A water-insulation layer 175 separated the LED 176 from the water bath 177.

C. One LED lead was directly connected to the time-varying power source while the other lead was connected to a material or substance that enhances electric field across the EL device via a dielectric layer. In this embodiment, the LED terminal 171 was connected directly to the time-varying power source time-varying power source described above, without a dielectric layer 172, while the other LED terminal 174 was connected to a material or substance that enhances electric field across the EL device via a dielectric layer 173. A water-insulation layer 175 separated the LED 176 from the water bath 177.

D. One LED lead was directly connected to a material or substance that enhances electric field across the EL device while the other lead was connected to the time-varying power source via a dielectric layer. In this embodiment, the LED terminal 171 was connected directly to a material or substance that enhances electric field across the EL device, without a dielectric layer 172, while the other LED terminal 174 was connected to the time-varying power source described above via a dielectric layer 173. A water-insulation layer 175 separated the LED 176 from the water bath 177.

E. All components were insulated and submerged in water. In this embodiment, the LED terminals 171 and 174 were connected to a material or substance that enhances electric field across the EL device and the time-varying power source described above, via a dielectric layer 172 and 173. A water-insulation layer 175 separated the LED 176 from the water bath 177.

Example 13 with Reference to Figure 18 - In these embodiments, EL devices were excited in a conductive medium using a device depicted in Figure 18. In these embodiments, commercial phosphor material was applied directly onto the exposed tip of an otherwise insulated electrode. The phosphor material was then coated with barium titanate dielectric layer and air-dried. The phosphor-coated electrode was submerged in water. The device used for these embodiments is illustrated in Figure 18. In each of the alternative embodiments in this example, the object that increases the electric field across the EL device is the water bath and an optional second object connected to the EL device directly or indirectly through the water bath. Light intensity produced is correlated to the presence and size of the field-increasing object(s). The following combinations were tested and produced light.

The insulated electrode was directly connected to an external ground while the water bath was energized. As shown in Figure 18, the electrode 181 attached to an EL layer 186 is insulated from water 183 and is directly connected to a body without a dielectric layer 182. The water bath 187 is connected by a single wire to the time-varying power source described above via an electrode 184 without a dielectric 185.

The insulated electrode was connected to an external ground via a dielectric layer while the water bath was energized. As shown in Figure 18, the electrode 181 attached to an EL layer 186 is insulated from water 183 and is connected to a body via a dielectric layer 182. The water bath 187 is connected to the time-varying power source described above by a single wire via an electrode 184 without a dielectric 185.

The insulated electrode was directly connected to an external time-varying power source while the water bath was grounded. As shown in Figure 18, the electrode 181 attached to an EL layer 186 is insulated from water 183 and is directly connected by a single wire to the time-varying power source described above without a dielectric layer 182. The water bath 187 is connected to a body via an electrode 184 without a dielectric 185.

D. The insulated electrode was connected by a single wire to an external time-varying power source via a dielectric layer while the water bath was grounded. As shown in Figure 18, the electrode 181 attached to an EL layer 186 is insulated from water 183 and is connected by a single wire to the time-varying power source described above via a dielectric layer 182. The water bath 187 is connected to a body via an electrode 184 without a dielectric 185.

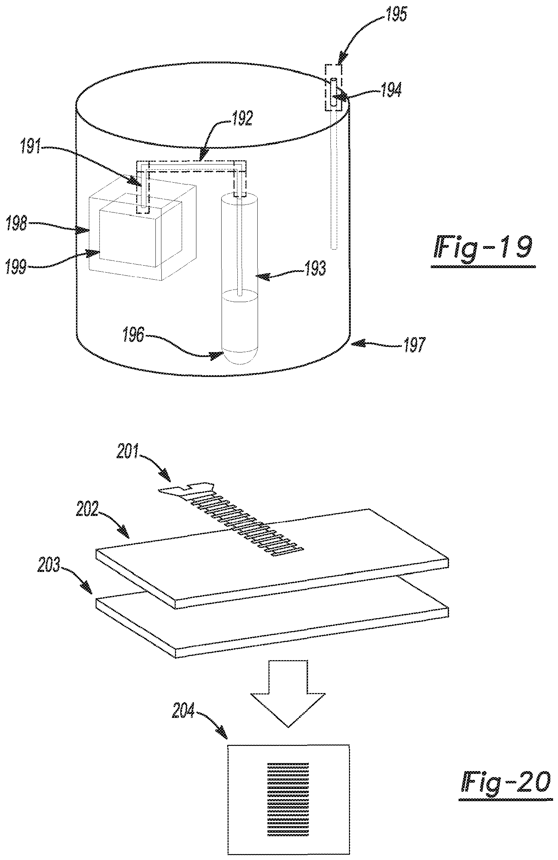

Example 14 with Reference to Figure 19 - In these embodiments, EL devices were excited in a conductive medium using a device depicted in Figure 19. In these embodiments, commercial phosphor material was applied directly onto the exposed tip of an otherwise insulated electrode. The phosphor material was then coated with barium titanate dielectric layer and air-dried. The phosphor-coated electrode was submerged in water. The device used for these embodiments is illustrated in Figure 19. In each of the alternative embodiments in this example, the object that increases the electric field across the EL device is the water bath and an optional second object connected to the EL device directly or indirectly through the water bath. Light intensity produced is correlated to the presence and size of the field-increasing object(s). The following combinations were tested and produced light.

The insulated electrode was directly connected to an insulated ground in water while the water bath was energized. In the schematic below, the electrode 191 attached to an EL layer 196 is insulated from water 193 and is connected to body 199 without a dielectric layer 192. Body 199 is stored in a water-sealed container 198. The water bath 197 is connected to the time-varying power source described above by a single wire via an electrode 194 without a dielectric 195.

The insulated electrode was connected to an insulated ground in water via a dielectric layer while the water bath was energized. In the schematic below, the electrode 191 attached to an EL layer 196 is insulated from water 193 and is connected to body 199 via a dielectric layer 192. Body 199 is stored in a water-sealed container 198. The water bath 197 is connected by a single wire to the time-varying power source described above (not shown) via an electrode 194 without a dielectric 195.

The insulated electrode was directly connected to an insulated power supply in water while the water bath was grounded. In the schematic below, the electrode 191 attached to an EL layer 196 is insulated from water 193 and is connected by a single wire to the time-varying power source described above 199 via a dielectric layer 192. The power source is stored in a water-sealed container 198. The water bath 197 is connected to a body via an electrode 194 without a dielectric 195.

The insulated electrode was connected to an insulated power supply in water via a dielectric layer while the water bath was grounded. In the schematic below, the electrode 191 attached to an EL layer 196 is insulated from water 193 and is connected by a single wire to the time-varying power source described above 199 via a dielectric layer 192. The power source is stored in a water-sealed container 198. The water bath 197 is connected to a body via an electrode 194 without a dielectric 195. The water bath and the EL device are connected (directly or via a dielectric layer) to a water-sealed body and the water-sealed power source which are all submerged in water.

Example 15 with Reference to Figure 20 - Various combinations of electrode, EL layer, and dielectric layer were examined in preparing a planar EL device for use in single wire methods. In one embodiment, a conductive body 201 is connected directly onto an EL layer 202. The EL layer sits directly on top of a transparent electrode 203 that is connected by a single wire to a time-varying power source by a single wire. No dielectric layer is applied between the EL layer and the electrode. As shown in Figure 20, upon excitation, a pattern 204 appears due to local enhancement by the presence of conductive body 201.

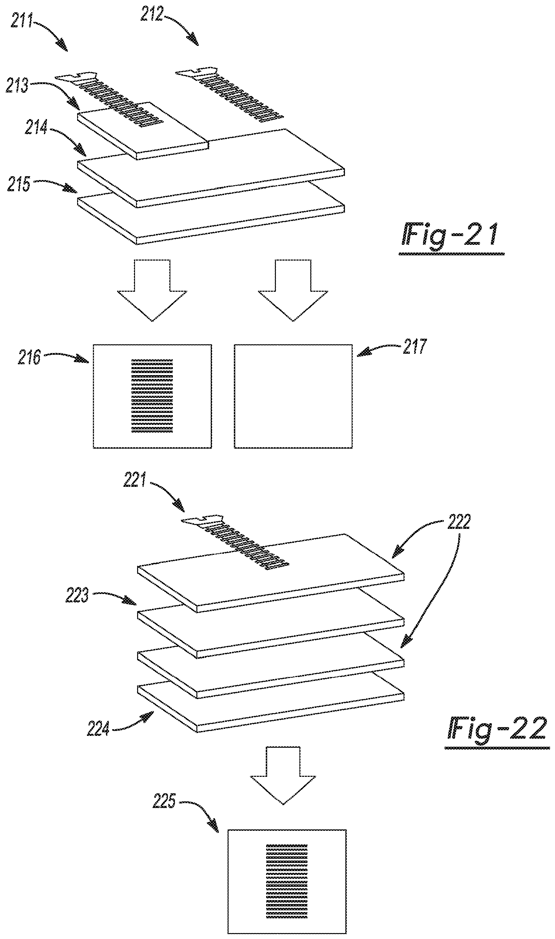

Example 16 with Reference to Figure 21 - In another embodiment, a dielectric layer 214 of BaTiO3 is placed on a surface of the transparent electrode 215 that is connected to a time-varying power source by a single wire. Then an EL layer 213 is placed over a portion of the dielectric layer. Two bodies 211 and 212 are connected directly onto the top surface of EL device as depicted in Figure 21. The setup with the EL layer results in an emitting pattern 216 due to local enhancement by the presence of body 21. On the other hand, in the setup with no EL layer, no emission is observed 217.

Example 17 with Reference to Figure 22 - In this embodiment, body 221 is connected to an EL device where two dielectric layers 222 sandwich an EL layer 223 between them. The system of the dielectric layers and the EL layer is laid over a transparent electrode 224 that is connected to a time-varying power source by a single wire. Upon excitation, a pattern 225 appears due to local enhancement by the presence of body 221.

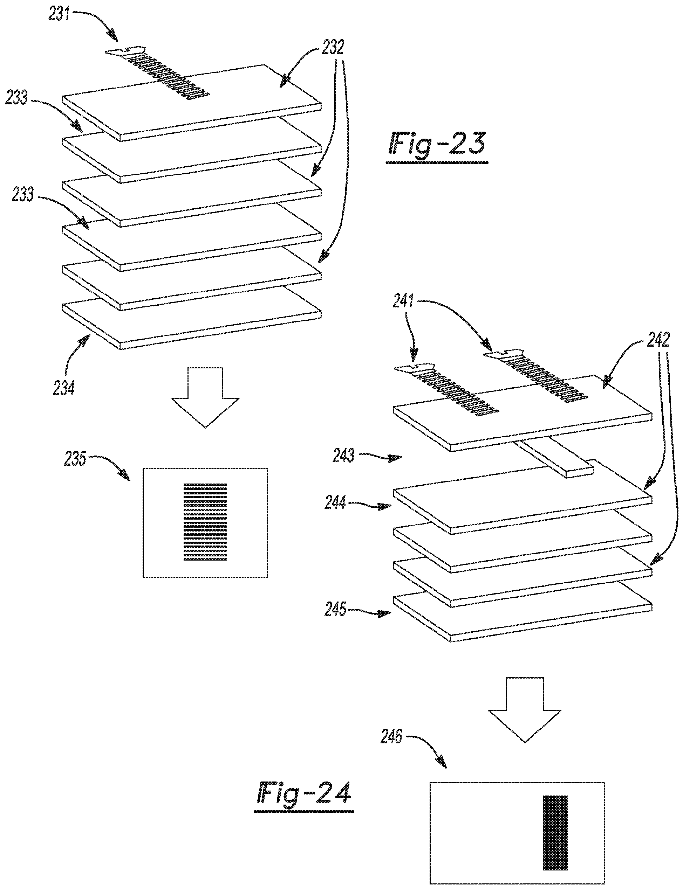

Example 18 with Reference to Figure 23 - Demonstrating the use of more than one EL layer. The result was shown to produce various colors depending on the excitation conditions. In these embodiments, a body 231 is attached to an EL device. The EL device consists of dielectric layers 232 which separate the EL layers 233. The two or more EL layers do not have to be separated, i.e. they can be in direct contact with one another or separated by dielectric layers. The system of the dielectric layers and EL layers are laid above a transparent electrode 234 that is connected by a single wire to a time-varying power source. Depending on the applied voltage, the observed emission pattern 235 due to local enhancement by the presence of body 231 appears differently. This difference could be in the output color, light intensity, etc. In addition, there could be more than one electrode exciting the EL layer. In an alternative embodiment one of the EL layers shown can be a layer of a fluorescent or phosphorescent material that serves to shift the wavelength of emission from the other layer by radiative or nonradiative energy transfer.

Example 19 with Reference to Figure 24 - Use of metallic nanoparticles or nanostructures (ex. nanotubes) for localized field enhancement: A layer of patterned metal NPs is added between the dielectric layers and the EL layer in order to modify the electric field strength across the EL layer. This allows the electric field to be selectively focused only on a portion of the EL layer for partial and more intense excitation.

In this embodiment, body 241 is connected to an EL device. The EL device contains several layers of dielectric 242. A conductive layer 243 focuses the electric field across the EL layer 244 such that only a portion of the EL layer emits light. Upon excitation of the transparent electrode 245, which is connected to a time-varying power source by a single wire, only the portion of EL layer coated with the conductive material emits light 246 due to local enhancement by body 241. In further embodiments, by patterning the conductive layer as desired (e.g., pixel, barcode, etc.), a binary output can be enabled.

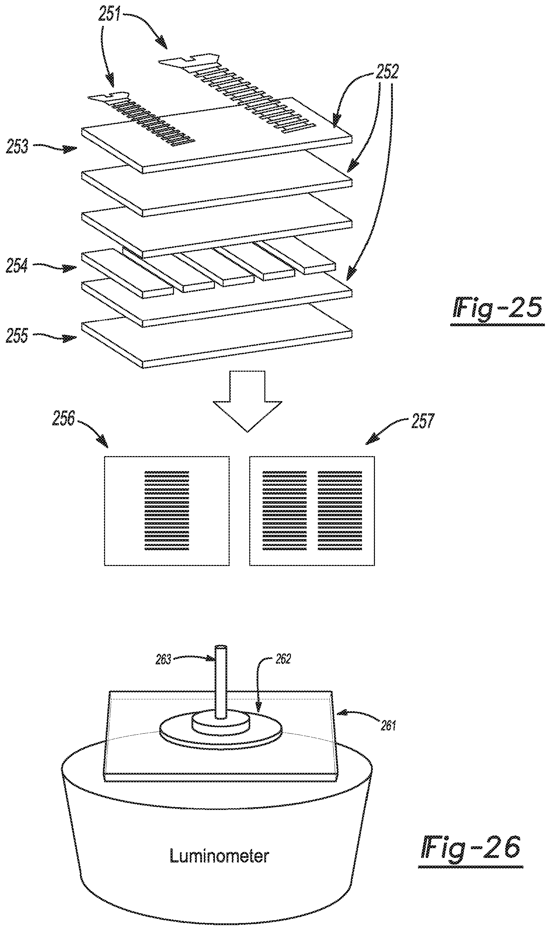

Example 20 with Reference to Figure 25 - This example illustrates the use of the present methods to produce a device for imaging objects in discrete picture elements.

In this example, body 251 is attached to an EL device. The EL device consists of several layers of dielectric 252 separating the different EL layers. Various EL layers can be implemented. For instance, one EL layer 253 can uniformly coat the dielectric layer for a uniform output. On the other hand, compartmentalized EL layers 254 can be used to distinguish between bodies of different size and surface area. In the embodiment shown in Figure 25, the EL layer consists of a substructure (i.e., pixel). The dielectric layers and EL layers sit on top of a transparent electrode 255 that is connected by a single wire to a time-varying power source. Depending on the size and surface area of body 251, a unique and distinctive pattern 256 or 257 will appear.

Example 21 with Reference to Figure 26 - In another embodiment, the size of the electric field-increasing object (attached to electrode 263) was kept constant while the input electrical energy was varied. The device luminance was measured and plotted as a function of input electrical energy. This method, compliments alternative ground size measurement where the ground size is varied as a function of luminance while the input electrical energy remains constant. In both circumstances, the size of an unknown ground can be derived from the relationship between luminance and the variable input electrical energy or ground size.

In this example, the transparent electrode 261 is directly connected to a time-varying power source. The mixture of EL layer and the dielectric layer 262 is applied onto the transparent electrode. An electrode 263 is used to connect the material or substance of unknown size (not shown) to the EL layer. The change in luminance due to the change in input electrical energy is recorded by the luminometer. A plot of luminance vs. current will exhibit a curve which can be expressed by a first equation. Repeating the process with different size sample of the same material will yield a family of such curves each expressed by their own characteristic equations. The size or other properties of a test material can therefore be derived. Alternatively, tables can be constructed of luminance vs. size or other properties of interest of the substance or material at different input energies and consulted to calibrate the system with and standardize the results.

The same techniques described in this example can also be applied to identically sized substances of different polarity or dielectric constant thereby deriving characteristic polarity or dielectric constant of an unknown substance or material.

Example 22 with Reference to Figures 27 and 28 - In another example embodiment, the method of the present invention was used to measure the effect of the length of the electric field pathway on light intensity. A red LED 271 was used as the electroluminescent device. The LED 271 was placed inside a luminometer 272. One terminal of the LED was fixed inside a tube with adjustable length 273 filled with tap water. A single wire from a time-varying power source 274 was fixed inside the other side of tube 273. The other leg of the LED 271 was not attached to anything, so that the electroluminescent device was at open-circuit. The intensity of the signal with different length of the tube 273 was tested. The intensity of the signal from the LED was recorded in the luminometer, with varying length of the tube. The extracted data shown in Figure 28 indicates that the intensity of the signal from the LED is inversely proportional to the length of the field pathway.

Example 23: (direct - remote - container as sensor) - The apparatus of example 1 was used in a fluid-level sensing method. A second terminal of the electroluminescent device (LED) was connected to a wire, and the wire was fixed inside a container, alongside the inner wall of the container. With increasing the level of the fluid inside the container, the signal of the electroluminescent device increased, which was recorded by a photosensor. In another example, the wire was connected to the second terminal of the electroluminescent device, and was fixed outside of the container alongside the wall of the container (remote sensing). Changing the fluid inside the container altered the signal of the electroluminescent device. In yet another example, the container was a conductive body. The second terminal of the electroluminescent device was connected to the container and the container served as the sensor.

Example 24 with reference to Figure 33 (measuring plurality of properties with different methods) - This example demonstrates both the type and quantity of an unknown liquid being measured. In this example, the electroluminescent device was an LED 341. The first terminal of the electroluminescent device was connected to the power source 342 via a time-varying electrical signal transmitting terminal. The second terminal of the LED was connected to a switch 343, with two switchable output terminals. One output terminal was connected to a small plate 344 (type sensor) which was placed under a container 345. The second output terminal was a wire 346 (volume sensor) that was fixed inside the container, alongside the inner wall of the container. A photosensor 347 recorded the magnitude of the electromagnetic radiation from the electroluminescent device. With changing the fluid inside the container, the signal of the type sensor reached a plateau value which was related to the type of the fluid inside the container (Table 2). The signal of the volume sensor indicated the quantity of the fluid. (Table 3).

In another example, instead of having a switch, two electroluminescent devices were separately used for the type sensor and the volume sensor.

Other examples are presented for measuring a plurality of properties. In an example experiment, a fixed quantity of the sample was separated from the bulk of a fluid with unknown type and quantity. The signal of the electroluminescent device for the fixed quantity of the sample indicated the type of fluid, and the signal of the electroluminescent device for the bulk of the fluid determines the quantity of the sample.

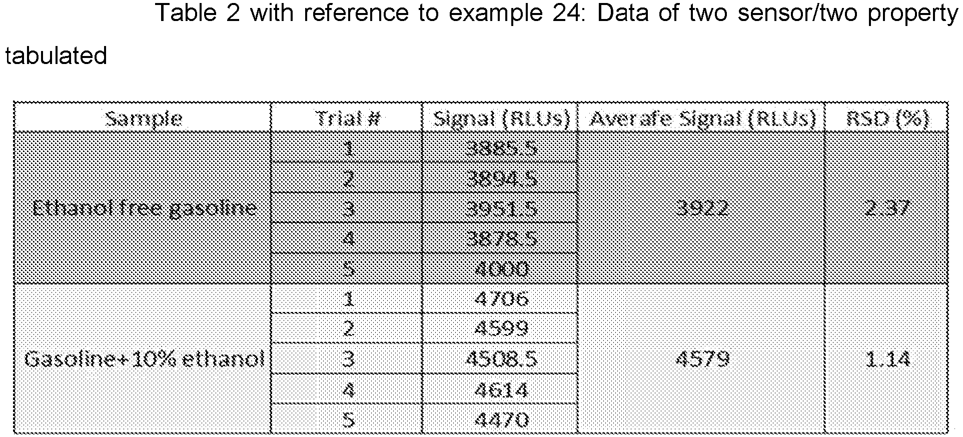

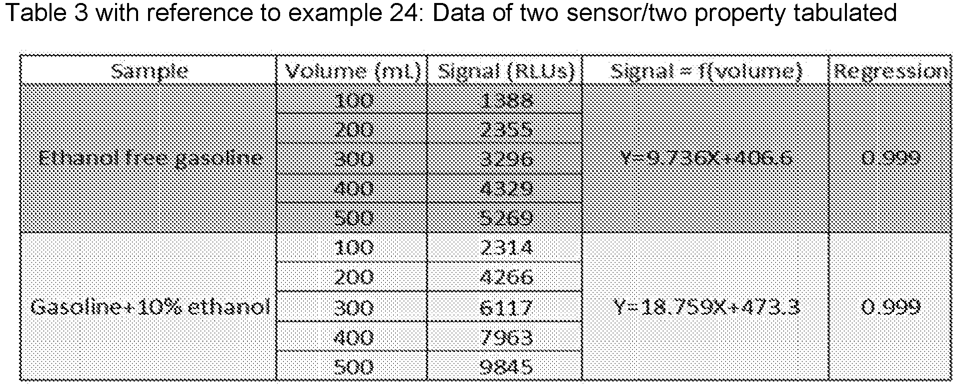

The information to relate the EL radiation to a physical property may be provided in a table or derived from a calibration curve particularly generated for the setup under study.

In another example, the objective was to distinguish metallic rivets of the same volume based on their type. To achieve this, the first terminal of an electroluminescent device was connected to a time-varying electrical signal supply, and the second terminal of the electroluminescent device was connected to a sensor that is a conductive surface (ITO glass). The response of the electroluminescent device was recorded by a photosensor, for each sample. The sample included an aluminum rivet, steel rivet, and a rivet of unknown type. The output value of the electroluminescent device indicates the type of the tested metal. The order of electromagnetic radiation intensity, the signals, from the largest to the smallest, for the three rivets were: 1) Steel (400 RLUs), 2) Aluminium (350 RLUs), and 3) the unknown (100 RLUs). The measurements further indicated that the unknown rivet was neither steel or aluminum. The applicant envisions an object sorting machine that uses the above-mentioned setup.

In a similar experiment, the samples include different volumes (mass) of metal rivets of the same type. By changing the number of metallic rivets positioned in close proximity to the sensor the total volume of the sample on the sensor changes. The change in sensor results in a change in the output electromagnetic radiation. The change in output electromagnetic radiation was then related to the number of the rivets.

Example 25 (Gas phase) - In another example, the type of different material in gas phase is measured using an open-circuit electroluminescent device. In this example, the first terminal of the electroluminescent device is connected to a time-varying electrical signal supply. The second terminal of the electroluminescent device is connected to the wire, and the wire is in a container in the overhead space of a mixture of two solvents with different boiling points. A heater is bringing the solvents to the boiling point, with the solvent with lower boiling point starting to boil and fill the overhead space. The electroluminescent device detects a signal related to the first solvent in gaseous phase. The signal remains constant until the first solvent completely evaporates, and the second solvent (with higher boiling point) starts to boil. At this point, replacing the first solvent in the overhead space with the second solvent in gaseous phase alters the output signal of the electroluminescent device.

Example 26 Voltage sweep - In another example, the time-varying electrical signal transmitting terminal of the power source was connected to one end of the EL device. The EL device was placed against a photosensor with the photosensor having a light intensity threshold. The other end of the EL device was connected to a wire that was fixed inside the container so that the bottom of the wire was level with the bottom of the container and goes alongside the height of the container. The container was filled with water whose level was to be measured. A threshold electromagnetic radiation is determined in advance. The time-varying electrical signal was varied for each unknown volume of water samples until the predetermined electromagnetic radiation threshold was reached. The time-varying electrical signal was related to the volume of the water sample.

In one example, the input voltage of a power supply was varied until the electromagnetic radiation output of the electroluminescent device reached 1000 RLUs for three unknown volumes of water. The volume of the water samples were derived from a calibration curve of voltage and water volume.

Example 27 (Solution potential) - In another example, the objective was to measure the electrical potential of a solution. To achieve this, the time-varying electrical signal transmitting terminal of the power source was connected to the first terminal of an LED. The LED was placed against a photosensor and the other terminal of the LED was connected to a wire that extended to a container filled with water. The time-varying electrical signal transmitting terminal of a second power source was also placed inside the water container. Changing the amplitude of the time-varying electrical signal of the second power source altered the electromagnetic radiation of the electroluminescent device. In some examples, the second power source was fed by an electrochemical cell, and the electromagnetic radiation was related to the potential of the electrochemical cell.

In another example, the above setup was used while the content of the container was changed with known volumes of solutions with unknown physical properties. Electromagnetic radiation was related to unknown physical properties of the solutions.

Experiment 28 (Latent fingerprint) - In one embodiment, the present methods may be employed in producing a signal for creating an image of a fingerprint for identification or security purposes. The present methods can be applied to imaging other areas of skin, regions of other animal bodies and even inanimate objects and for obtaining information about the properties, including the size or surface characteristics such as textures of objects in contact.

Such a portion of tissue or tissue section is conveniently applied or adhered to a conventional glass slide of the type used in microscopy techniques. Such sections may be of any convenient thickness and thus are not particularly limited in this regard. Use of semiconductor phosphor particles of sufficiently small size or diameter permits microscopic imaging to be performed.

The present example describes application of a method for electroluminescent illustration of a latent fingerprint lifted from a surface of an object. In this example, the fingerprint of a subject was formed on the surface of a glass slide by pressing a finger to the surface. A sample of EL phosphor powder was sprinkled over the surface of the glass slide, thus adhering to residual substances from the fingertip that were left on the glass surface, and the excess powder was dusted off using a brush. Then a clear tape was used to pick up the residue of the EL phosphor powder whose shape and distribution reproduced the pattern of the subject's fingerprint, from the glass slide. To construct the EL device, the tape with the phosphor powder removed from the surface of the glass slide was fixed on the conductive side of an ITO glass. Then one wire of the power source was connected to the ITO glass. The ITO glass was placed against a flat conductive surface as counter electrode, so that the backside of the tape contacted the conductive surface. The patterned phosphor powder emitted luminescence, reproducing the pattern of the fingerprint. In a separate example, the same method was used for mapping the surface features of another object. For this the EL phosphor powder was sprinkled over the surface of the object (coin in this example), then a clear tape was used to pick up the EL phosphor powder from the object, duplicating the features of the surface. The EL of the phosphor powder illustrated the surface features of the object.

Example 29 Topography of conductive surfaces - In this example the EL device (sensor) was prepared by sandwiching EL phosphor powder between the conductive side of ITO plastic and a dielectric (clear tape in this example). The hot wire of a power source was connected to the ITO plastic. The sensor was placed against the surface of a conductive object with a surface feature, so that the conductive object with a surface feature was acting as the counter-electrode. The resulting electroluminescent image illustrated the feature on the surface of the conductive object.

In another example, the EL device (sensor) was prepared by sandwiching EL phosphor powder between the conductive side of ITO plastic and a dielectric (clear tape in this example). Using a razor blade, a fine scratch was made on the surface of an Al plate. The sensor was placed against the Al plate, so that the Al plate acted as counter-electrode. The resulting electroluminescent image illustrated the scratch map on the surface of the Al plate.

The foregoing description of the embodiments has been provided for purposes of illustration and description. It is not intended to be exhaustive or to limit the disclosure. Individual elements or features of a particular embodiment are generally not limited to that particular embodiment, but, where applicable, are interchangeable and can be used in a selected embodiment, even if not specifically shown or described. The same may also be varied in many ways. Such variations are not to be regarded as a departure from the disclosure, and all such modifications are intended to be included within the scope of the disclosure.

## Claims

1. An electroluminescent method for measuring a physical property of an object comprising:
a. transmitting a time-varying electrical signal from a power source (12, 35, 53. 73, 83, 93, 124, 145, 274, 311, 331, 342) to a first terminal of an electroluminescent device (11, 31-32, 51, 71, 81, 91, 121-122, 142-143, 271, 312, 334, 341), wherein the electroluminescent device remains at open circuit in relation to the power source;
b. positioning an object in close proximity to the electroluminescent device while the time-varying electrical signal is transmitted to the electroluminescent device, such that the physical property of the object alters the time-varying electrical signal across the electroluminescent device and thereby changes electromagnetic radiation emitted by the electroluminescent device;
c. measuring the change in electromagnetic radiation emitted by the electroluminescent device; and
d. relating the measured change in electromagnetic radiation to the physical property of the object.

2. The method of Claim 1 wherein more than one physical property is measured.

3. The method of Claim 1 wherein more than one time-varying electrical signal is used.

4. The method of Claim 1 wherein more than one electroluminescent device is used.

5. The method of Claim 1 wherein the object is separated from the electroluminescent device by a dielectric material (33, 55, 123, 141, 144).

6. The method of Claim 1 wherein the electroluminescent device has more than two terminals.

7. The method of Claim 1 wherein the physical property is selected from the group consisting of volume, mass, area, length, distance, position, orientation, speed, acceleration, displacement, density, concentration in a solution, pH, ionic strength, chemical composition, ratio of two substances in admixture, polarity, electrical potential, electrical charge content, conductivity, resistivity, capacitance, temperature, magnetic permeability, electric permittivity, refractive index, current density, vibration, oscillation, displacement, strain, stress, pressure, reflectivity, transparency, color, relative brightness, texture, rigidity, geometry, moisture content, absorptivity, energy, intensity, amplitude, frequency, mass-to-charge ratio, impurity, connectivity, mobility, viscosity, and pattern.

8. The method of Claim 1 wherein the electrical signal is comprised of a plurality of waveforms.

9. The method of Claim 1 wherein the electroluminescent device comprises materials selected from the group consisting of organic light emitting diodes, inorganic light emitting diodes, electroluminescent quantum dots, electroluminescent nanocrystals, inert gases, and combinations thereof.

10. The method of Claim 1 wherein the electroluminescent device comprises materials that convert electrical energy into thermal energy.

11. The method of Claim 1 wherein the electroluminescent device emits in infrared to ultraviolet wavelengths.

12. The method of Claim 1 wherein the electroluminescent device is comprised of a combination of luminescent materials.

13. The method of Claim 1 wherein the object is in solid phase, liquid phase or gas phase.

14. The method of Claim 1 wherein the physical property of the object can be altered by a change in an environmental condition.

15. The method of Claim 1 wherein the electrical signal is transmitted wirelessly from the power source to the electroluminescent device.

16. The method of Claim 15 further comprising:
e. transmitting a time-varying electrical signal from the power source to a primary coil (332);
f. coupling a secondary coil (333) to the primary coil, such that the time-varying electrical signal in the primary coil induces a time-varying signal in the secondary coil; and
g. attaching the secondary coil to a first terminal of an electroluminescent device.

17. The method of Claim 2 wherein measuring more than one physical property comprises measuring different properties of one object.

18. The method of Claim 2 wherein measuring more than one physical property comprises measuring one property of different objects.

19. The method of Claim 1 wherein the same physical property of a plurality of objects is measured.

20. The method of Claim 2 wherein at least one of the measurements is performed at closed circuit.

21. An electroluminescent method for measuring a physical property of an object comprising:
a. transmitting a time-varying electrical signal from a power source (321) to a first terminal of an electroluminescent device (322) and a circuit component (325), wherein the electroluminescent device and the circuit component remain at open circuit;
b. positioning an object in close proximity to the circuit component, such that a change in the physical property of the object alters the time-varying electrical signal across the circuit component and the electroluminescent device and thereby changes electromagnetic radiation emitted by the electroluminescent device;
c. measuring the change in electromagnetic radiation emitted by the electroluminescent device; and
d. relating the measured change in electromagnetic radiation to a physical property of the object,
wherein the circuit component and the electroluminescent device are configured in a series configuration, parallel configuration, or a combination thereof.

22. The method of Claim 21 wherein the circuit component is selected from a resistor which measures electrical resistivity of the object, a capacitor which measures capacitive properties of the object, an inductor which measures inductive properties of the object, a photodiode which measures optical properties of the object, a thermocouple, wherein the thermocouple measures thermal properties of the object, a piezoelectric sensor, wherein the piezoelectric sensor measures a mechanical property of the object, and an electrochemical cell, wherein the electrochemical cell measures electrical potential of the object.

23. The method of Claim 22 wherein the photodiode is selected from the group consisting of photovoltaic cells, thermophotovoltaics, thermopile, and photodetectors.

24. The method of Claim 21 wherein the physical property is selected from the group consisting of volume, mass, area, length, distance, position, orientation, speed, acceleration, displacement, density, concentration in a solution, pH, ionic strength, ratio of two substances in admixture, polarity, conductivity, resistivity, capacitance, temperature, permeability, permittivity, refractive index, current density, vibration, oscillation, displacement, strain, stress, pressure, reflectivity, transparency, color, relative brightness, texture, rigidity, geometry, moisture content, absorptivity, energy, intensity, amplitude, frequency, mass-to-charge ratio, impurity, connectivity, mobility, viscosity, and pattern.

25. The method of Claim 21 wherein more than one circuit component is used.

26. The method of Claim 21 wherein the circuit component is disposed in an insulating material.

27. The method of Claim 21 wherein the object is a second circuit component.

28. The method of Claim 27 wherein the second circuit component is selected from the group consisting of a resistor, inductor, electrochemical cell, direct current power source, and time-varying power source.

29. The method of Claim 21 wherein the electrical signal is transmitted wirelessly from the power source to the electroluminescent device.

30. The method of Claim 21 further comprising:
e. transmitting a time-varying electrical signal from the power source to a primary coil;
f. coupling a secondary coil to the primary coil, such that the time-varying electrical signal in the primary coil induces a time-varying signal in the secondary coil; and
g. attaching the secondary coil to a first terminal of an electroluminescent device.

31. The method of Claim 1 wherein a property of the time-varying electrical signal is adjusted, said signal property being selected from the group consisting of amplitude, frequency, waveform, current, phase angle, or a combination thereof.

32. The method of Claim 31 wherein the adjustment in the time-varying electrical signal and the change in the electromagnetic radiation are related to the physical property of the object.

33. The method of Claim 32 wherein a voltage input to the power source is adjusted to change the time-varying electrical signal being transmitted to the electroluminescent device and thereby cause the electromagnetic radiation to be emitted at a preselected intensity, and relating the input voltage to the property of the object.

34. The method of claim 1 wherein the presence of the object positioned in close proximity to the electroluminescent device increases the amplitude of the time-varying electrical signal across the electroluminescent device.

35. The method of claim 1 wherein the electroluminescent device comprises a multiplicity of LEDs.

36. The method of claim 35 wherein more than one color of LED is used.

37. The method of claim 1 wherein the electroluminescent device comprises a transparent planar electrode and a phosphor material layer deposited on a surface of the planar electrode.

38. The method of claim 37 wherein the phosphor material layer covers one or more discrete regions of a surface of the electrode.

39. The method of claim 38 wherein a plurality of different phosphor materials is used and wherein each region is covered with a single phosphor material and wherein each of the different phosphor materials emits light of a different color.

40. The method of claim 1 wherein the time-varying electrical current is transmitted from the power source to the electroluminescent device by a single transmitting conductor selected from a conductive lead or a fluid.

41. The method of claim 1 wherein the object in close proximity to the electroluminescent device is selected from a part of a body, a human fingertip, or a tissue section.

42. The method of claim 1 wherein the object is a liquid contained in a vessel and wherein the vessel contacts the electroluminescent device.

43. The method of claim 1 wherein the time-varying electrical current is alternating current having a frequency in the range of 1 Hz to 200 kHz or the time-varying electrical signal has a waveform selected from the group consisting of sinusoidal, square, sawtooth, and pulsed waveforms.

44. The method of claim 1, wherein
the object is a fluid ;
the time-varying electrical signal is transmitted from a power source through a single electrical terminal to the electroluminescent device through the fluid;
the amplitude of the time-varying electrical signal across the electroluminescent device is increased and thereby generates light from the electroluminescent device;
the intensity of the light emitted by the electroluminescent device is measured; and
the measured light intensity is related to the property of the fluid.

45. The method of claim 44 wherein the property is selected from the group consisting of mass, volume, conductivity, dielectric constant, polarity, concentration of a solute, and pH.

46. The method of claim 44 wherein the fluid is contained in a tube of fixed cross section and length and wherein light intensity generated by the electroluminescent device is proportional to the length of the tube.

47. The method of claim 46 wherein the fluid is positioned between the electroluminescent device and the power source.

48. The method of claim 44 wherein the fluid surrounds the electroluminescent device.

## Patentansprüche

1. Elektrolumineszenzverfahren zum Messen einer physikalischen Eigenschaft eines Objekts, umfassend:
a. Übertragen eines zeitvariablen elektrischen Signals von einer Stromquelle (12, 35, 53, 73, 83, 93, 124, 145, 274, 311, 331, 342) an einen ersten Anschluss einer Elektrolumineszenzvorrichtung (11, 31-32, 51, 71, 81, 91, 121-122, 142-143, 271, 312, 334, 341), wobei die Elektrolumineszenzvorrichtung in Bezug auf die Stromquelle in einem offenen Stromkreis bleibt;
b. Positionieren eines Objekts in großer Nähe zu der Elektrolumineszenzvorrichtung, während das zeitvariable elektrische Signal an die Elektrolumineszenzvorrichtung übertragen wird, so dass die physikalische Eigenschaft des Objekts das zeitvariable elektrische Signal durch die Elektrolumineszenzvorrichtung ändert und dadurch von der Elektrolumineszenzvorrichtung ausgestrahlte elektromagnetische Strahlung ändert;
c. Messen der Änderung der von der Elektrolumineszenzvorrichtung ausgestrahlten elektromagnetischen Strahlung; und
d. in Bezug setzen der gemessenen Änderung der elektromagnetischen Strahlung mit der physikalischen Eigenschaft des Objekts.

2. Verfahren nach Anspruch 1, wobei mehr als eine physikalische Eigenschaft gemessen wird.

3. Verfahren nach Anspruch 1, wobei mehr als ein zeitvariables elektrisches Signal verwendet wird.

4. Verfahren nach Anspruch 1, wobei mehr als eine Elektrolumineszenzvorrichtung verwendet wird.

5. Verfahren nach Anspruch 1, wobei das Objekt von der Elektrolumineszenzvorrichtung durch ein dielektrisches Material (33, 55, 123, 141, 144) getrennt wird.

6. Verfahren nach Anspruch 1, wobei die Elektrolumineszenzvorrichtung mehr als zwei Anschlüsse aufweist.

7. Verfahren nach Anspruch 1, wobei die physikalische Eigenschaft aus der Gruppe ausgewählt ist, die aus Volumen, Masse, Fläche, Länge, Abstand, Position, Ausrichtung, Geschwindigkeit, Beschleunigung, Verdrängung, Dichte, Konzentration in einer Lösung, pH-Wert, Ionenstärke, chemischer Zusammensetzung, Verhältnis von zwei Substanzen im Gemisch, Polarität, elektrischem Potential, elektrischem Ladungsgehalt, Leitfähigkeit, spezifischem Widerstand, Kapazität, Temperatur, magnetischer Durchlässigkeit, elektrischer Permittivität, Brechungsindex, Stromdichte, Vibration, Schwingung, Verdrängung, Beanspruchung, Belastung, Druck, Reflexionsvermögen, Transparenz, Farbe, relativer Helligkeit, Textur, Starrheit, Geometrie, Feuchtigkeitsgehalt, Absorptionsvermögen, Energie, Intensität, Amplitude, Frequenz, Masse-/Ladungsverhältnis, Verunreinigung, Verbindungsfähigkeit, Mobilität, Viskosität und Muster besteht.

8. Verfahren nach Anspruch 1, wobei das elektrische Signal aus einer Vielzahl von Wellenformen besteht.

9. Verfahren nach Anspruch 1, wobei die Elektrolumineszenzvorrichtung Materialien umfasst, die aus der Gruppe ausgewählt sind, die aus organischen Leuchtdioden, anorganischen Leuchtdioden, Elektrolumineszenz-Quantenpunkten, Elektrolumineszenz-Nanokristallen, inerten Gasen und Kombinationen davon besteht.

10. Verfahren nach Anspruch 1, wobei die Elektrolumineszenzvorrichtung Materialien umfasst, die elektrische Energie in Wärmeenergie umwandeln.

11. Verfahren nach Anspruch 1, wobei die Elektrolumineszenzvorrichtung in Infrarotbis Ultraviolett-Wellenlängen ausstrahlt.

12. Verfahren nach Anspruch 1, wobei die Elektrolumineszenzvorrichtung aus einer Kombination aus Lumineszenzmaterialien besteht.

13. Verfahren nach Anspruch 1, wobei das Objekt in fester Phase, flüssiger Phase oder Gasphase vorliegt.

14. Verfahren nach Anspruch 1, wobei die physikalische Eigenschaft des Objekts durch eine Änderung einer Umgebungsbedingung geändert werden kann.

15. Verfahren nach Anspruch 1, wobei das elektrische Signal drahtlos von der Stromquelle zu der Elektrolumineszenzvorrichtung übertragen wird.

16. Verfahren nach Anspruch 15, ferner umfassend:
e. Übertragen eines zeitvariablen elektrischen Signals von der Stromquelle zu einer Primärwicklung (332);
f. Koppeln einer Sekundärwicklung (333) an die Primärwicklung, so dass das zeitvariable elektrische Signal in der Primärwicklung ein zeitvariables Signal in der Sekundärwicklung induziert; und
g. Anbringen der Sekundärwicklung an einem ersten Anschluss einer Elektrolumineszenzvorrichtung.

17. Verfahren nach Anspruch 2, wobei das Messen von mehr als einer physikalischen Eigenschaft das Messen von verschiedenen Eigenschaften von einem Objekt umfasst.

18. Verfahren nach Anspruch 2, wobei das Messen von mehr als einer physikalischen Eigenschaft das Messen einer einzigen Eigenschaft von verschiedenen Objekten umfasst.

19. Verfahren nach Anspruch 1, wobei die gleiche physikalische Eigenschaft einer Vielzahl von Objekten gemessen wird.

20. Verfahren nach Anspruch 2, wobei mindestens eine der Messungen bei geschlossenem Stromkreis ausgeführt wird.

21. Elektrolumineszenzverfahren zum Messen einer physikalischen Eigenschaft eines Objekts, umfassend:
a. Übertragen eines zeitvariablen elektrischen Signals von einer Stromquelle (321) an einen ersten Anschluss einer Elektrolumineszenzvorrichtung (322) und einer Schaltungskomponente (325), wobei die Elektrolumineszenzvorrichtung und die Schaltungskomponente in einem offenen Stromkreis bleiben;
b. Positionieren eines Objekts in großer Nähe zu der Schaltungskomponente, so dass eine Änderung der physikalischen Eigenschaft des Objekts das zeitvariable elektrische Signal durch die Schaltungskomponente und die Elektrolumineszenzvorrichtung ändert und dadurch eine von der Elektrolumineszenzvorrichtung ausgestrahlte elektromagnetische Strahlung ändert;
c. Messen der Änderung der von der Elektrolumineszenzvorrichtung ausgestrahlten elektromagnetischen Strahlung; und
d. in Bezug setzen der gemessenen Änderung der elektromagnetischen Strahlung mit einer physikalischen Eigenschaft des Objekts,
wobei die Schaltungskomponente und die Elektrolumineszenzvorrichtung in einer Reihenkonfiguration, einer parallelen Konfiguration oder einer Kombination davon konfiguriert sind.

22. Verfahren nach Anspruch 21, wobei die Schaltungskomponente ausgewählt ist aus einem Widerstand, der den elektrischen spezifischen Widerstand des Objekts misst, einem Kondensator, der kapazitive Eigenschaften des Objekts misst, einem Induktor, der induktive Eigenschaften des Objekts misst, einer Photodiode, die optische Eigenschaften des Objekts misst, einem Thermoelement, wobei das Thermoelement thermische Eigenschaften des Objekts misst, einem piezoelektrischen Sensor, wobei der piezoelektrische Sensor eine mechanische Eigenschaft des Objekts misst, und einer elektrochemischen Zelle, wobei die elektrochemische Zelle ein elektrisches Potential des Objekts misst.

23. Verfahren nach Anspruch 22, wobei die Photodiode aus der Gruppe ausgewählt ist, die aus Photovoltaikzellen, Thermophotovoltaik, Thermosäule und Photodetektoren besteht.

24. Verfahren nach Anspruch 21, wobei die physikalische Eigenschaft aus der Gruppe ausgewählt ist, die aus Volumen, Masse, Fläche, Länge, Abstand, Position, Ausrichtung, Geschwindigkeit, Beschleunigung, Verdrängung, Dichte, Konzentration in einer Lösung, pH-Wert, Ionenstärke, Verhältnis von zwei Substanzen im Gemisch, Polarität, Leitfähigkeit, spezifischem Widerstand, Kapazität, Temperatur, Durchlässigkeit, Permittivität, Brechungsindex, Stromdichte, Vibration, Schwingung, Verdrängung, Beanspruchung, Belastung, Druck, Reflexionsvermögen, Transparenz, Farbe, relativer Helligkeit, Textur, Starrheit, Geometrie, Feuchtigkeitsgehalt, Absorptionsvermögen, Energie, Intensität, Amplitude, Frequenz, Masse-/Ladungsverhältnis, Verunreinigung, Verbindungsfähigkeit, Mobilität, Viskosität und Muster besteht.

25. Verfahren nach Anspruch 21, wobei mehr als eine Schaltungskomponente verwendet wird.

26. Verfahren nach Anspruch 21, wobei die Schaltungskomponente in einem Isoliermaterial angeordnet ist.

27. Verfahren nach Anspruch 21, wobei das Objekt eine zweite Schaltungskomponente ist.

28. Verfahren nach Anspruch 27, wobei die zweite Schaltungskomponente aus der Gruppe ausgewählt ist, die aus einem Widerstand, einem Induktor, einer elektrochemischen Zelle, einer Gleichstromquelle und einer zeitvariablen Stromquelle besteht.

29. Verfahren nach Anspruch 21, wobei das elektrische Signal drahtlos von der Stromquelle zu der Elektrolumineszenzvorrichtung übertragen wird.

30. Verfahren nach Anspruch 21, ferner umfassend:
e. Übertragen eines zeitvariablen elektrischen Signals von der Stromquelle zu einer Primärwicklung;
f. Koppeln einer Sekundärwicklung an die Primärwicklung, so dass das zeitvariable elektrische Signal in der Primärwicklung ein zeitvariables Signal in der Sekundärwicklung induziert; und
g. Anbringen der Sekundärwicklung an einem ersten Anschluss einer Elektrolumineszenzvorrichtung.

31. Verfahren nach Anspruch 1, wobei eine Eigenschaft des zeitvariablen elektrischen Signals eingestellt wird, wobei die Signaleigenschaft aus der Gruppe ausgewählt ist, die aus Amplitude, Frequenz, Wellenform, Strom, Phasenwinkel oder einer Kombination davon besteht.

32. Verfahren nach Anspruch 31, wobei die Einstellung des zeitvariablen elektrischen Signals und die Änderung der elektromagnetischen Strahlung mit der physikalischen Eigenschaft des Objekts in Beziehung gesetzt werden.

33. Verfahren nach Anspruch 32, wobei eine Spannungseingabe in die Stromquelle eingestellt ist, um das zeitvariable elektrische Signal zu ändern, das an die Elektrolumineszenzvorrichtung übertragen wird, und dadurch ein Ausstrahlen der elektromagnetischen Strahlung mit einer vorausgewählten Intensität zu bewirken, und das die Eingangsspannung mit der Eigenschaft des Objekts in Beziehung setzt.

34. Verfahren nach Anspruch 1, wobei das Vorliegen des Objekts, das in großer Nähe zu der Elektrolumineszenzvorrichtung positioniert ist, die Amplitude des zeitvariablen elektrischen Signals durch die Elektrolumineszenzvorrichtung vergrößert.

35. Verfahren nach Anspruch 1, wobei die Elektrolumineszenzvorrichtung eine Vielfalt von LEDs umfasst.

36. Verfahren nach Anspruch 35, wobei mehr als eine Farbe der LED verwendet wird.

37. Verfahren nach Anspruch 1, wobei die Elektrolumineszenzvorrichtung eine transparente planare Elektrode und eine Phosphormaterialschicht, die auf eine Oberfläche der planaren Elektrode abgelagert wird, umfasst.

38. Verfahren nach Anspruch 37, wobei die Phosphormaterialschicht einen oder mehr diskrete Bereiche einer Oberfläche der Elektrode bedeckt.

39. Verfahren nach Anspruch 38, wobei eine Vielzahl von verschiedenen Phosphormaterialien verwendet wird und wobei jeder Bereich mit einem einzelnen Phosphormaterial bedeckt wird und wobei jedes von den verschiedenen Phosphormaterialien Licht mit einer anderen Farbe ausstrahlt.

40. Verfahren nach Anspruch 1, wobei der zeitvariable elektrische Strom durch einen einzelnen Übertragungsleiter, der aus einem leitfähigen Blei oder einem Fluid ausgewählt ist, von der Stromquelle zu der Elektrolumineszenzvorrichtung übertragen wird.

41. Verfahren nach Anspruch 1, wobei das Objekt in großer Nähe zu der Elektrolumineszenzvorrichtung aus einem Teil eines Körpers, einer menschlichen Fingerspitze oder einem Gewebeabschnitt ausgewählt ist.

42. Verfahren nach Anspruch 1, wobei das Objekt eine Flüssigkeit ist, die in einem Gefäß enthalten ist, und wobei das Gefäß die Elektrolumineszenzvorrichtung berührt.

43. Verfahren nach Anspruch 1, wobei der zeitvariable elektrische Strom Wechselstrom mit einer Frequenz im Bereich von 1 Hz bis 200 kHz ist oder das zeitvariable elektrische Signal eine Wellenform aufweist, die aus der Gruppe ausgewählt ist, die aus sinusförmigen, quadratischen, sägezahnförmigen und gepulsten Wellenformen besteht.

44. Verfahren nach Anspruch 1, wobei
das Objekt ein Fluid ist;
das zeitvariable elektrische Signal durch das Fluid von einer Stromquelle durch einen einzelnen elektrischen Anschluss an die Elektrolumineszenzvorrichtung übertragen wird;
die Amplitude des zeitvariablen elektrischen Signals durch die Elektrolumineszenzvorrichtung erhöht wird und dadurch Licht von der Elektrolumineszenzvorrichtung erzeugt;
die Intensität des von der Elektrolumineszenzvorrichtung ausgestrahlten Lichts gemessen wird, und
die gemessene Lichtintensität mit der Eigenschaft des Fluids in Beziehung gesetzt wird.

45. Verfahren nach Anspruch 44, wobei die Eigenschaft aus der Gruppe ausgewählt ist, die aus Masse, Volumen, Leitfähigkeit, Dielektrizitätskonstante, Polarität, Konzentration eines gelösten Stoffs und pH-Wert besteht.

46. Verfahren nach Anspruch 44, wobei das Fluid in einem Rohr von einem festen Querschnitt und einer festen Länge enthalten ist, und wobei die von der Elektrolumineszenzvorrichtung erzeugte Lichtintensität proportional zu der Länge des Rohrs ist.

47. Verfahren nach Anspruch 46, wobei das Fluid zwischen der Elektrolumineszenzvorrichtung und der Stromquelle positioniert ist.

48. Verfahren nach Anspruch 44, wobei das Fluid die Elektrolumineszenzvorrichtung umgibt.

## Revendications

1. Procédé électroluminescent pour mesurer une propriété physique d'un objet, comprenant :
a. la transmission d'un signal électrique variant en fonction du temps depuis une source d'alimentation (12, 35, 53, 73, 83, 93, 124, 145, 274, 311, 331, 342) sur une première borne d'un dispositif électroluminescent (11, 31-32, 51, 71, 81, 91, 121-122, 142-143, 271, 312, 334, 341), dans lequel le dispositif électroluminescent reste en circuit ouvert en relation avec la source d'alimentation ;
b. le positionnement d'un objet à proximité étroite du dispositif électroluminescent tandis que le signal électrique variant en fonction du temps est transmis sur le dispositif électroluminescent, de telle sorte que la propriété physique de l'objet altère le signal électrique variant en fonction du temps aux bornes du dispositif électroluminescent et modifie ainsi un rayonnement électromagnétique émis par le dispositif électroluminescent ;
c. la mesure de la modification du rayonnement électromagnétique émis par le dispositif électroluminescent ; et
d. le fait de rapporter la modification mesurée du rayonnement électromagnétique à la propriété physique de l'objet.

2. Procédé selon la revendication 1, dans lequel plus d'une propriété physique est mesurée.

3. Procédé selon la revendication 1, dans lequel plus d'un signal électrique variant en fonction du temps est utilisé.

4. Procédé selon la revendication 1, dans lequel plus d'un dispositif électroluminescent est utilisé.

5. Procédé selon la revendication 1, dans lequel l'objet est séparé du dispositif électroluminescent par un matériau diélectrique (33, 55, 123, 141, 144).

6. Procédé selon la revendication 1, dans lequel le dispositif électroluminescent comporte plus de deux bornes.

7. Procédé selon la revendication 1, dans lequel la propriété physique est sélectionnée parmi le groupe constitué par le volume, la masse, l'aire, la longueur, la distance, la position, l'orientation, la vitesse, l'accélération, le déplacement, la densité, la concentration dans une solution, le pH, la force ionique, la composition chimique, le rapport de deux substances en mélange, la polarité, le potentiel électrique, le contenu en termes de charges électriques, la conductivité, la résistivité, la capacité, la température, la perméabilité magnétique, la permittivité électrique, l'indice de réfraction, la densité de courant, la vibration, l'oscillation, le déplacement, la déformation, la contrainte, la pression, la réflectivité, la transparence, la couleur, la luminosité relative, la texture, la rigidité, la géométrie, la teneur en humidité, la capacité d'absorption, l'énergie, l'intensité, l'amplitude, la fréquence, le rapport masse sur charges, l'impureté, la connectivité, la mobilité, la viscosité et le motif.

8. Procédé selon la revendication 1, dans lequel le signal électrique est constitué par une pluralité de formes d'onde.

9. Procédé selon la revendication 1, dans lequel le dispositif électroluminescent comprend des matériaux sélectionnés parmi le groupe constitué par les diodes électroluminescentes organiques, les diodes électroluminescentes inorganiques, les points quantiques électroluminescents, les nano-cristaux électroluminescents, les gaz inertes et des combinaisons de ceux-ci.

10. Procédé selon la revendication 1, dans lequel le dispositif électroluminescent comprend des matériaux qui convertissent l'énergie électrique en énergie thermique.

11. Procédé selon la revendication 1, dans lequel le dispositif électroluminescent émet dans les longueurs d'onde des infrarouges aux ultraviolets.

12. Procédé selon la revendication 1, dans lequel le dispositif électroluminescent est constitué par une combinaison de matériaux luminescents.

13. Procédé selon la revendication 1, dans lequel l'objet est en phase solide, en phase liquide ou en phase gazeuse.

14. Procédé selon la revendication 1, dans lequel la propriété physique de l'objet peut être altérée par une modification d'une condition environnementale.

15. Procédé selon la revendication 1, dans lequel le signal électrique est émis sans fil depuis la source d'alimentation sur le dispositif électroluminescent.

16. Procédé selon la revendication 15, comprenant en outre :
e. la transmission d'un signal électrique variant en fonction du temps depuis la source d'alimentation sur une bobine primaire (332) ;
f. le couplage d'une bobine secondaire (333) à la bobine primaire, de telle sorte que le signal électrique variant en fonction du temps dans la bobine primaire induise un signal variant en fonction du temps dans la bobine secondaire ; et
g. la liaison de la bobine secondaire à une première borne d'un dispositif électroluminescent.

17. Procédé selon la revendication 2, dans lequel la mesure de plus d'une propriété physique comprend la mesure de différentes propriétés d'un objet.

18. Procédé selon la revendication 2, dans lequel la mesure de plus d'une propriété physique comprend la mesure d'une seule propriété de différents objets.

19. Procédé selon la revendication 1, dans lequel la même propriété physique d'une pluralité d'objets est mesurée.

20. Procédé selon la revendication 2, dans lequel au moins l'une des mesures est réalisée en circuit fermé.

21. Procédé électroluminescent pour mesurer une propriété physique d'un objet, comprenant :
a. la transmission d'un signal électrique variant en fonction du temps depuis une source d'alimentation (321) sur une première borne d'un dispositif électroluminescent (322) et d'un composant de circuit (325), dans lequel le dispositif électroluminescent et le composant de circuit restent en circuit ouvert;
b. le positionnement d'un objet à proximité étroite du composant de circuit, de telle sorte qu'une modification de la propriété physique de l'objet altère le signal électrique variant en fonction du temps aux bornes du composant de circuit et du dispositif électroluminescent et modifie ainsi un rayonnement électromagnétique émis par le dispositif électroluminescent ;
c. la mesure de la modification du rayonnement électromagnétique émis par le dispositif électroluminescent ; et
d. le fait de rapporter la modification mesurée du rayonnement électromagnétique à une propriété physique de l'objet,
dans lequel le composant de circuit et le dispositif électroluminescent sont configurés dans une configuration série, une configuration parallèle ou une combinaison de celles-ci.

22. Procédé selon la revendication 21, dans lequel le composant de circuit est sélectionné parmi une résistance qui mesure la résistivité électrique de l'objet, un condensateur qui mesure des propriétés capacitives de l'objet, un inducteur qui mesure des propriétés inductives de l'objet, une photodiode qui mesure des propriétés optiques de l'objet, un thermocouple, dans lequel le thermocouple mesure des propriétés thermiques de l'objet, un capteur piézoélectrique, dans lequel le capteur piézoélectrique mesure une propriété mécanique de l'objet, et une cellule électrochimique, dans lequel la cellule électrochimique mesure un potentiel électrique de l'objet.

23. Procédé selon la revendication 22, dans lequel la photodiode est sélectionnée parmi le groupe constitué par les cellules photovoltaïques, les éléments thermo-photovoltaïques, les thermopiles et les photo-détecteurs.

24. Procédé selon la revendication 21, dans lequel la propriété physique est sélectionnée parmi le groupe constitué par le volume, la masse, l'aire, la longueur, la distance, la position, l'orientation, la vitesse, l'accélération, le déplacement, la densité, la concentration dans une solution, le pH, la force ionique, le rapport de deux substances en mélange, la polarité, la conductivité, la résistivité, la capacité, la température, la perméabilité, la permittivité, l'indice de réfraction, la densité de courant, la vibration, l'oscillation, le déplacement, la déformation, la contrainte, la pression, la réflectivité, la transparence, la couleur, la luminosité relative, la texture, la rigidité, la géométrie, la teneur en humidité, la capacité d'absorption, l'énergie, l'intensité, l'amplitude, la fréquence, le rapport masse sur charges, l'impureté, la connectivité, la mobilité, la viscosité et le motif.

25. Procédé selon la revendication 21, dans lequel plus d'un composant de circuit est utilisé.

26. Procédé selon la revendication 21, dans lequel le composant de circuit est disposé dans un matériau isolant.

27. Procédé selon la revendication 21, dans lequel l'objet est un second composant de circuit.

28. Procédé selon la revendication 27, dans lequel le second composant de circuit est sélectionné parmi le groupe constitué par une résistance, un inducteur, une cellule électrochimique, une source d'alimentation courant continu et une source d'alimentation variant en fonction du temps.

29. Procédé selon la revendication 21, dans lequel le signal électrique est transmis sans fil depuis la source d'alimentation au dispositif électroluminescent.

30. Procédé selon la revendication 21, comprenant en outre :
e. la transmission d'un signal électrique variant en fonction du temps depuis la source d'alimentation à une bobine primaire ;
f. le couplage d'une bobine secondaire à la bobine primaire, de telle sorte que le signal électrique variant en fonction du temps dans la bobine primaire induise un signal variant en fonction du temps dans la bobine secondaire ; et
g. la liaison de la bobine secondaire à une première borne d'un dispositif électroluminescent.

31. Procédé selon la revendication 1, dans lequel une propriété du signal électrique variant en fonction du temps est réglée, ladite propriété de signal étant sélectionnée parmi le groupe constitué par l'amplitude, la fréquence, la forme d'onde, le courant, l'angle de phase ou une combinaison de ceux-ci.

32. Procédé selon la revendication 31, dans lequel le réglage du signal électrique variant en fonction du temps et la modification du rayonnement électromagnétique sont rapportés à la propriété physique de l'objet.

33. Procédé selon la revendication 32, dans lequel une entrée de tension pour la source d'alimentation est réglée pour modifier le signal électrique variant en fonction du temps qui est transmis au dispositif électroluminescent et pour provoquer ainsi l'émission du rayonnement électromagnétique selon une intensité présélectionnée, et rapportant la tension d'entrée à la propriété de l'objet.

34. Procédé selon la revendication 1, dans lequel la présence de l'objet positionné à proximité étroite du dispositif électroluminescent augmente l'amplitude du signal électrique variant en fonction du temps aux bornes du dispositif électroluminescent.

35. Procédé selon la revendication 1, dans lequel le dispositif électroluminescent comprend une multiplicité de DEL.

36. Procédé selon la revendication 35, dans lequel plus d'une couleur de DEL est utilisée.

37. Procédé selon la revendication 1, dans lequel le dispositif électroluminescent comprend une électrode plane transparente et une couche de matériau de phosphore déposée sur une surface de l'électrode plane.

38. Procédé selon la revendication 37, dans lequel la couche de matériau de phosphore recouvre une ou plusieurs régions discrètes d'une surface de l'électrode.

39. Procédé selon la revendication 38, dans lequel une pluralité de différents matériaux de phosphore est utilisée et dans lequel chaque région est recouverte d'un unique matériau de phosphore et dans lequel chacun des différents matériaux de phosphore émet une lumière d'une couleur différente.

40. Procédé selon la revendication 1, dans lequel le courant électrique variant en fonction du temps est transmis depuis la source d'alimentation au dispositif électroluminescent par un unique conducteur de transmission sélectionné parmi un fil conducteur ou un fluide.

41. Procédé selon la revendication 1, dans lequel l'objet à proximité étroite du dispositif électroluminescent est sélectionné parmi une partie d'un corps, le bout d'un doigt humain ou une section de tissu.

42. Procédé selon la revendication 1, dans lequel l'objet est un liquide contenu dans un récipient et dans lequel le récipient est en contact avec le dispositif électroluminescent.

43. Procédé selon la revendication 1, dans lequel le courant électrique variant en fonction du temps est un courant alternatif présentant une fréquence dans la plage de 1 Hz à 200 kHz ou le signal électrique variant en fonction du temps présente une forme d'onde sélectionnée parmi le groupe constitué par les formes d'onde sinusoïdale, carrée, en dents de scie et pulsée.

44. Procédé selon la revendication 1, dans lequel :
l'objet est un fluide ;
le signal électrique variant en fonction du temps est transmis depuis une source d'alimentation au travers d'une unique borne électrique jusqu'au dispositif électroluminescent au travers du fluide ;
l'amplitude du signal électrique variant en fonction du temps aux bornes du dispositif électroluminescent est augmentée et amène ainsi le dispositif électroluminescent à générer de la lumière ;
l'intensité de la lumière émise par le dispositif électroluminescent est mesurée ; et
l'intensité de lumière mesurée est rapportée à la propriété du fluide.

45. Procédé selon la revendication 44, dans lequel la propriété est sélectionnée parmi le groupe constitué par la masse, le volume, la conductivité, la constante diélectrique, la polarité, la concentration d'un soluté et le pH.

46. Procédé selon la revendication 44, dans lequel le fluide est contenu dans un tube d'une section en coupe transversale et d'une longueur fixes, et dans lequel l'intensité lumineuse générée par le dispositif électroluminescent est proportionnelle à la longueur du tube.

47. Procédé selon la revendication 46, dans lequel le fluide est positionné entre le dispositif électroluminescent et la source d'alimentation.

48. Procédé selon la revendication 44, dans lequel le fluide entoure le dispositif électroluminescent.
